# EUROPEAN PATENT APPLICATION

(11) **EP 4 195 903 A1**
(43) Date of publication of application: **14.06.2023**
(21) Application number: 22203246.8
(22) Date of filing: 24.10.2022
(51) Int. Cl.: H10K 59/32, H10K 50/13, H10K 50/12, H10K 85/30

(54) **ORGANIC LIGHT EMITTING DISPLAY DEVICE**

(30) Priority: 10.12.2021 KR 20210176762
(71) Applicant: LG Display Co., Ltd., SEOUL, 07336 (KR)
(72) Inventor: SHIN, In-Ae, 10845 Paju-si (KR); MIN, Hye-Li, 10845 Paju-si (KR); RYU, Young-Ju, 10845 Paju-si (KR); LEE, Ji-Ae, 10845 Paju-si (KR); LIM, Gi-Hwan, 10845 Paju-si (KR); KIM, Jun-Yun, 10845 Paju-si (KR)
(74) Representative: Cousens, Nico

(57) **Abstract**

An organic light emitting display device includes a substrate including first to third pixel regions; and an organic light emitting diode including a transparent electrode, a reflective electrode and a light emitting layer between the transparent electrode and the reflective electrode, wherein the light emitting layer in the organic light emitting diode in the first pixel region includes a first emitting part including a first emitting material layer and second emitting part including a second emitting material layer, and the second emitting part is positioned between the first emitting material layer and the transparent electrode, wherein the light emitting layer in the organic light emitting diode in the second pixel region includes a third emitting part including a third emitting material layer and fourth emitting part including a fourth emitting material layer, and the fourth emitting part is positioned between the third emitting material layer and the transparent electrode, and wherein each of the first and fourth emitting material layers is a fluorescent emitting layer, and each of the second and third emitting material layers is a phosphorescent emitting layer.

## Description

### CROSS-REFERENCE TO RELATED APPLICATIONS

The present application claims the benefit of Korean Patent Application No. 10-2021-0176762 filed in the Republic of Korea on December 10, 2021.

### BACKGROUND

### TECHNICAL FIELD

The present disclosure relates to an organic light emitting display device, and more particularly, to an organic light emitting display device having high display performance.

### DISCUSSION OF THE RELATED ART

Requirement for flat panel display devices having small occupied area is increased. Among the flat panel display devices, a technology of an organic light emitting display device, which includes an organic light emitting diode (OLED) and may be called an organic electroluminescent device, is rapidly developed.

The OLED emits light by injecting electrons from a cathode as an electron injection electrode and holes from an anode as a hole injection electrode into an emitting material layer, combining the electrons with the holes, generating an exciton, and transforming the exciton from an excited state to a ground state.

A fluorescent material may be used as an emitter in the OLED. However, since only singlet exciton of the fluorescent material is involved in the emission, there is a limitation in the emitting efficiency of the fluorescent material.

### SUMMARY

Accordingly, embodiments of the present disclosure are directed to an organic light emitting display device that substantially obviates one or more of the problems associated with the limitations and disadvantages of the related art.

An invention is defined in the independent claims. An object of the present disclosure is to provide an organic light emitting display device having high display performance.

Additional features and aspects will be set forth in the description that follows, and in part will be apparent from the description, or may be learned by practice of the present disclosure concepts provided herein. Other features and aspects of the present disclosure concepts may be realized and attained by the structure particularly pointed out in the written description, or derivable therefrom, and the claims hereof as well as the appended drawings.

To achieve these and other advantages in accordance with the purpose of the embodiments of the present disclosure, as described herein, an aspect of the present disclosure is an organic light emitting display device comprising: a substrate including first to third pixel regions; and an organic light emitting diode in each of the pixel regions, each organic light emitting diode including a transparent electrode, a reflective electrode and a light emitting layer between the transparent electrode and the reflective electrode, wherein the light emitting layer in the organic light emitting diode in the first pixel region includes a first emitting part including a first emitting material layer and second emitting part including a second emitting material layer, and the second emitting part is positioned between the first emitting material layer and the transparent electrode, wherein the first emitting material layer is a fluorescent emitting layer, and the second emitting material layer is a phosphorescent emitting layer, and wherein a full width at a half maximum of the second emitting material layer is smaller than that of the first emitting material layer, and an emitting efficiency of the second emitting material layer is greater than that of the first emitting material layer.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the present disclosure and are incorporated in and constitute a part of this application, illustrate embodiments of the present disclosure and together with the description serve to explain principles of the present disclosure.
FIG. 1 is a schematic circuit diagram of an organic light emitting display device of the present disclosure.
FIG. 2 is a schematic cross-sectional view of an organic light emitting display device according to a first embodiment of the present disclosure.
FIG. 3 is a schematic cross-sectional view of an organic light emitting display device according to a second embodiment of the present disclosure.
FIG. 4 is a schematic cross-sectional view showing a pixel region of the organic light emitting display device according to the first embodiment of the present disclosure.
FIG. 5 is a schematic cross-sectional view of an OLED of an organic light emitting display device according to a third embodiment of the present disclosure.
FIG. 6 is a schematic cross-sectional view of an OLED in a red pixel region of an organic light emitting display device according to a fourth embodiment of the present disclosure.
FIG. 7 is a schematic cross-sectional view of an OLED in a green pixel region of an organic light emitting display device according to the fourth embodiment of the present disclosure.
FIG. 8 is a schematic cross-sectional view of an OLED in a red pixel region of an organic light emitting display device according to a fifth embodiment of the present disclosure.
FIG. 9 is a schematic cross-sectional view of an OLED in a green pixel region of an organic light emitting display device according to the fifth embodiment of the present disclosure.

### DETAILED DESCRIPTION

Reference will now be made in detail to some of the examples and preferred embodiments, which are illustrated in the accompanying drawings.

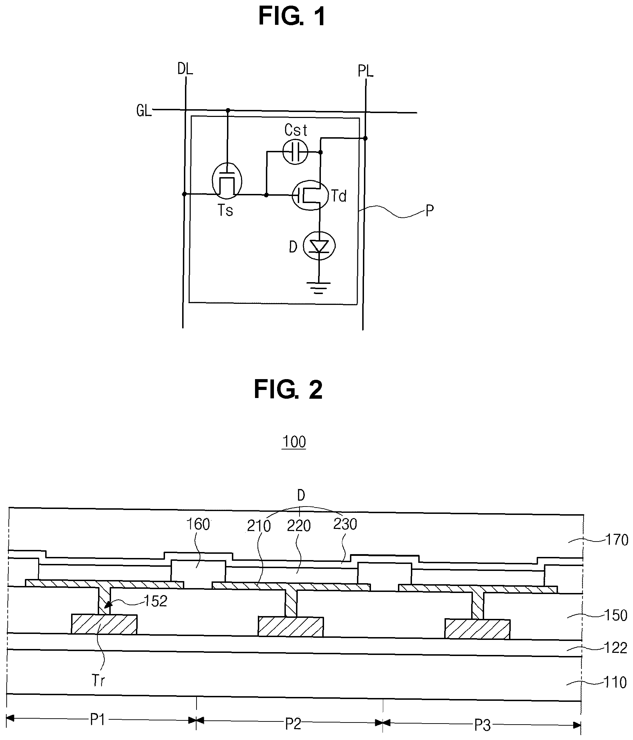

FIG. 1 is a schematic circuit diagram of an organic light emitting display device of the present disclosure.

As shown in FIG. 1, an organic light emitting display device includes a gate line GL, a data line DL, a power line PL, a switching thin film transistor "TFT" Ts, a driving TFT Td, a storage capacitor Cst, and an OLED D. The gate line GL and the data line DL cross each other to define a pixel region P. The pixel region may include or may be a red pixel region, a green pixel region and a blue pixel region.

The switching TFT Ts is connected to the gate line GL and the data line DL, and the driving TFT Td and the storage capacitor Cst are connected to the switching TFT Ts and the power line PL. The OLED D is connected to the driving TFT Td.

In the organic light emitting display device, when the switching TFT Ts is turned on by a gate signal applied through the gate line GL, a data signal from the data line DL is applied to the gate electrode of the driving TFT Td and an electrode of the storage capacitor Cst.

When the driving TFT Td is turned on by the data signal, an electric current is supplied to the OLED D from the power line PL. As a result, the OLED D emits light. In this case, when the driving TFT Td is turned on, a level of an electric current applied from the power line PL to the OLED D is determined such that the OLED D can produce a gray scale.

The storage capacitor Cst serves to maintain the voltage of the gate electrode of the driving TFT Td when the switching TFT Ts is turned off. Accordingly, even if the switching TFT Ts is turned off, a level of an electric current applied from the power line PL to the OLED D is maintained to next frame.

As a result, the organic light emitting display device displays a desired image.

FIG. 2 is a schematic cross-sectional view of an organic light emitting display device according to a first embodiment of the present disclosure.

As shown in FIG. 2, the organic light emitting display device 100 includes a substrate 110, where first to third pixel regions P1, P2 and P3 are defined, a TFT Tr on or over the substrate 110 and an OLED D over the TFT Tr and connected to the TFT Tr.

For example, the first pixel region P1 may be a red pixel region, the second pixel region P2 may be a green pixel region, and the third pixel region P3 may be a blue pixel region. The first to third pixel regions P1 to P3 constitute a pixel unit. Optionally, the pixel unit may further include a fourth pixel region being a white pixel region.

The substrate 110 may be a glass substrate or a flexible substrate.

A buffer layer 122 is formed on the substrate, and the TFT Tr is formed on the buffer layer 122. The buffer layer 122 may be omitted.

The TFT Tr is disposed on the buffer layer 122. The TFT Tr includes a semiconductor layer, a gate electrode, a source electrode and a drain electrode and acts as a driving element. Namely, the TFT Tr may be the driving TFT Td (of FIG. 1).

A planarization layer 150 is disposed on the TFT Tr. The planarization layer 150 has a flat top surface and includes a drain contact hole 152 exposing the drain electrode of the TFT Tr.

An OLED D is disposed on the planarization layer 150 and includes a first electrode 210, a light emitting layer 220 and a second electrode 230. The first electrode 210 is connected to the drain electrode of the TFT Tr through the drain contact hole 152, and the light emitting layer 220 and the second electrode 230 are sequentially stacked on the first electrode 210. The OLED D is positioned in each of the first to third pixel regions P1 to P3 and emits different color lights in each of the first to third pixel regions P1 to P3. For example, the OLED D in the first pixel region may provide the red emission, the OLED D in the second pixel region P2 may provide the green emission, and the OLED D in the third pixel region P3 may provide the blue emission.

The first electrode 210 may be formed to be separated in each of the first to third pixel regions P1 to P3, and the second electrode 230 may be formed as one-body in correspondence to the first to third pixel regions P1 to P3.

The first electrode 210 is one of an anode and a cathode, and the second electrode 230 is the other one of the anode and the cathode. The first electrode 210 is a reflection (also known as a reflective electrode), and second electrode 230 is a transparent (or semi-transparent) electrode. Namely, the light from the light-emitting layer passes through the second electrode 230 to display an image (a top-emission type organic light emitting display device).

For example, the first electrode 210 may be an anode and may include a transparent conductive oxide material layer, which has a relatively high work function, and a reflection layer.

The second electrode 230 may be a cathode and may include a conductive material having a relatively low work function. The second electrode 230 has a thin profile to be transparent (or semi-transparent).

The light emitting layer 220 as an emission unit may have a single-layered structure of an emitting material layer (EML). Alternatively, the light emitting layer 220 may further include at least one of a hole injection layer (HIL), a hole transport layer (HTL), an electron blocking layer (EBL), a hole blocking layer (HBL), an electron transport layer (ETL) and an electron injection layer (EIL) to have a multi-layered structure. In addition, two or more emission units may be disposed to be separated such that the OLED D may have a tandem structure.

Although not shown, the OLED D may further include a capping layer on the second electrode 230. The emitting efficiency of the OLED D may be further improved by the capping layer.

An encapsulation film (or an encapsulation layer) 170 is formed on the second electrode 230 to prevent penetration of moisture into the OLED D. The encapsulation film 170 may have a structure in which an inorganic insulating layer and an organic insulating layer are stacked.

Although not shown, the organic light emitting display device 100 may include a color filter corresponding to the first to third pixel regions P1 to P3. For example, the color filter may be positioned on or over the OLED D or the encapsulation film 170.

In addition, the organic light emitting display device 100 may further include a cover window (not shown) on or over the encapsulation film 170 or the color filter. In this instance, the substrate 110 and the cover window are flexible such that a flexible organic light emitting display device may be provided.

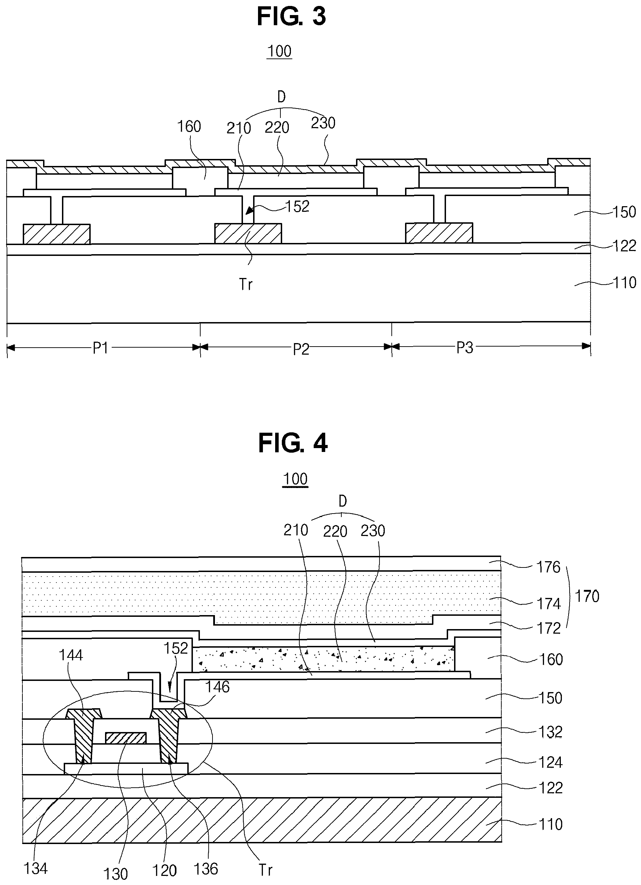

FIG. 3 is a schematic cross-sectional view of an organic light emitting display device according to a second embodiment of the present disclosure.

As shown in FIG. 3, the organic light emitting display device 100 includes a substrate 110, where first to third pixel regions P1, P2 and P3 are defined, a TFT Tr on or over the substrate 110 and an OLED D over the TFT Tr and connected to the TFT Tr.

For example, the first pixel region P1 may be a red pixel region, the second pixel region P2 may be a green pixel region, and the third pixel region P3 may be a blue pixel region. The first to third pixel regions P1 to P3 constitute a pixel unit. Optionally, the pixel unit may further include a fourth pixel region being a white pixel region.

The substrate 110 may be a glass substrate or a flexible substrate.

A buffer layer 122 is formed on the substrate, and the TFT Tr is formed on the buffer layer 122. The buffer layer 122 may be omitted.

The TFT Tr is disposed on the buffer layer 122. The TFT Tr includes a semiconductor layer, a gate electrode, a source electrode and a drain electrode and acts as a driving element. Namely, the TFT Tr may be the driving TFT Td (of FIG. 1).

A planarization layer 150 is disposed on the TFT Tr. The planarization layer 150 has a flat top surface and includes a drain contact hole 152 exposing the drain electrode of the TFT Tr.

An OLED D is disposed on the planarization layer 150 and includes a first electrode 210, a light emitting layer 220 and a second electrode 230. The first electrode 210 is connected to the drain electrode of the TFT Tr through the drain contact hole 152, and the light emitting layer 220 and the second electrode 230 are sequentially stacked on the first electrode 210. The OLED D is positioned in each of the first to third pixel regions P1 to P3 and emits different color lights in each of the first to third pixel regions P1 to P3. For example, the OLED D in the first pixel region may provide the red emission, the OLED D in the second pixel region P2 may provide the green emission, and the OLED D in the third pixel region P3 may provide the blue emission.

The first electrode 210 may be formed to be separated in each of the first to third pixel regions P1 to P3, and the second electrode 230 may be formed as one-body in correspondence to the first to third pixel regions P1 to P3.

The first electrode 210 is one of an anode and a cathode, and the second electrode 230 is the other one of the anode and the cathode. The first electrode 210 is a transparent (or semi-transparent) electrode, and second electrode 230 is a reflection electrode. Namely, the light from the light-emitting layer passes through the first electrode 210 to display an image on a side of the substrate 110 (a bottom-emission type organic light emitting display device).

For example, the first electrode 210 may be an anode and may include a conductive material, e.g., a transparent conductive oxide material (TCO), having a relatively high work function.

The second electrode 230 may be a cathode and may include a conductive material having a relatively low work function.

The light emitting layer 220 as an emission unit may have a single-layered structure of an emitting material layer (EML). Alternatively, the light emitting layer 220 may further include at least one of a hole injection layer (HIL), a hole transport layer (HTL), an electron blocking layer (EBL), a hole blocking layer (HBL), an electron transport layer (ETL) and an electron injection layer (EIL) to have a multi-layered structure. In addition, two or more emission units may be disposed to be separated such that the OLED D may have a tandem structure.

An encapsulation film (or an encapsulation layer) 170 is formed on the second electrode 230 to prevent penetration of moisture into the OLED D. The encapsulation film 170 may have a structure in which an inorganic insulating layer and an organic insulating layer are stacked.

Although not shown, the organic light emitting display device 100 may include a color filter corresponding to the first to third pixel regions P1 to P3. For example, the color filter may be positioned between the OLED D and the substrate 110.

FIG. 4 is a schematic cross-sectional view showing a pixel region of the organic light emitting display device according to the first embodiment of the present disclosure.

As shown in FIG. 4, the organic light emitting display device 100 includes a substrate 110, a TFT Tr on or over the substrate 110, a planarization layer 150 covering the TFT Tr and an OLED D on the planarization layer 150 and connected to the TFT Tr.

The substrate 110 may be a glass substrate or a flexible substrate. For example, the flexible substrate may be one of a polyimide (PI) substrate, a polyethersulfone (PES) substrate, a polyethylenenaphthalate (PEN) substrate, a polyethylene terephthalate (PET) substrate and a polycarbonate (PC) substrate.

A buffer layer 122 is formed on the substrate, and the TFT Tr is formed on the buffer layer 122. The buffer layer 122 may be omitted. For example, the buffer layer 122 may be formed of an inorganic insulating material, e.g., silicon oxide or silicon nitride.

A semiconductor layer 120 is formed on the buffer layer 122. The semiconductor layer 120 may include an oxide semiconductor material or polycrystalline silicon.

When the semiconductor layer 120 includes the oxide semiconductor material, a light-shielding pattern (not shown) may be formed under the semiconductor layer 120. The light to the semiconductor layer 120 is shielded or blocked by the light-shielding pattern such that thermal degradation of the semiconductor layer 120 can be prevented. On the other hand, when the semiconductor layer 120 includes polycrystalline silicon, impurities may be doped into both sides of the semiconductor layer 120.

A gate insulating layer 124 is formed on the semiconductor layer 120. The gate insulating layer 124 may be formed of an inorganic insulating material such as silicon oxide or silicon nitride.

A gate electrode 130, which is formed of a conductive material, e.g., metal, is formed on the gate insulating layer 124 to correspond to a center of the semiconductor layer 120. In FIG. 4, the gate insulating layer 124 is formed on an entire surface of the substrate 110. Alternatively, the gate insulating layer 124 may be patterned to have the same shape as the gate electrode 130.

An interlayer insulating layer 132 is formed on the gate electrode 130 and over an entire surface of the substrate 110. The interlayer insulating layer 132 may be formed of an inorganic insulating material, e.g., silicon oxide or silicon nitride, or an organic insulating material, e.g., benzocyclobutene or photo-acryl.

The interlayer insulating layer 132 includes first and second contact holes 134 and 136 exposing both sides of the semiconductor layer 120. The first and second contact holes 134 and 136 are positioned at both sides of the gate electrode 130 to be spaced apart from the gate electrode 130. The first and second contact holes 134 and 136 are formed through the gate insulating layer 124. Alternatively, when the gate insulating layer 124 is patterned to have the same shape as the gate electrode 130, the first and second contact holes 134 and 136 is formed only through the interlayer insulating layer 132.

A source electrode 144 and a drain electrode 146, which are formed of a conductive material, e.g., metal, are formed on the interlayer insulating layer 132. The source electrode 144 and the drain electrode 146 are spaced apart from each other with respect to the gate electrode 130 and respectively contact both sides of the semiconductor layer 120 through the first and second contact holes 134 and 136.

The semiconductor layer 120, the gate electrode 130, the source electrode 144 and the drain electrode 146 constitute the TFT Tr. The TFT Tr serves as a driving element. Namely, the TFT Tr is the driving TFT Td (of FIG. 1).

In the TFT Tr, the gate electrode 130, the source electrode 144, and the drain electrode 146 are positioned over the semiconductor layer 120. Namely, the TFT Tr has a coplanar structure. Alternatively, in the TFT Tr, the gate electrode may be positioned under the semiconductor layer, and the source and drain electrodes may be positioned over the semiconductor layer such that the TFT Tr may have an inverted staggered structure. In this instance, the semiconductor layer may include amorphous silicon.

Although not shown, the gate line and the data line cross each other to define the pixel region, and the switching TFT is formed to be connected to the gate and data lines. The switching TFT is connected to the TFT Tr as the driving element. In addition, the power line, which may be formed to be parallel to and spaced apart from one of the gate and data lines, and the storage capacitor for maintaining the voltage of the gate electrode of the TFT Tr in one frame may be further formed.

A planarization layer 150 is formed on (optionally, substantially) an entire surface of the substrate 110 to cover the source and drain electrodes 144 and 146. The planarization layer 150 provides a flat top surface and has a drain contact hole 152 exposing the drain electrode 146 of the TFT Tr.

The OLED D is disposed on the planarization layer 150 and includes a first electrode 210, which is connected to the drain electrode 146 of the TFT Tr, a light emitting layer 220 and a second electrode 230. The light emitting layer 220 and the second electrode 230 are sequentially stacked on the first electrode 210. The OLED D is positioned in each of the red, green and blue pixel regions and respectively emits red, green and blue light.

The first electrode 210 is separately formed in each pixel region. The first electrode 210 may be an anode and may include a transparent conductive oxide material layer, which may be formed of a conductive material, e.g., a transparent conductive oxide (TCO), having a relatively high work function, and a reflection layer.

Alternatively, in the organic light emitting display device according to the second embodiment of the present disclosure, the first electrode 210 may have a single-layered structure of the transparent conductive oxide material layer. In this case, the capping layer 290 may be omitted.

For example, the transparent conductive oxide material layer may be formed of one of indium-tin-oxide (ITO), indium-zinc-oxide (IZO), indium-tin-zinc-oxide (ITZO), tin oxide (SnO), zinc oxide (ZnO), indium-copper-oxide (ICO) and aluminum-zinc-oxide (AI:ZnO, AZO), and the reflection layer may be formed of one of silver (Ag), an alloy of Ag and one of palladium (Pd), copper (Cu), indium (In) and neodymium (Nd), and aluminum-palladium-copper (APC) alloy. For example, the first electrode 210 may have a structure of ITO/Ag/ITO or ITO/APC/ITO.

In addition, a bank layer 160 is formed on the planarization layer 150 to cover an edge of the first electrode 210. Namely, the bank layer 160 is positioned at a boundary of the pixel region and exposes a center of the first electrode 210 in the pixel region.

The light emitting layer 220 as an emission unit is formed on the first electrode 210. The light emitting layer 220 may have a single-layered structure of an emitting material layer (EML). Alternatively, the light emitting layer 220 may further include at least one of a hole injection layer (HIL), a hole transport layer (HTL), an electron blocking layer (EBL), a hole blocking layer (HBL), an electron transport layer (ETL) and an electron injection layer (EIL) to have a multi-layered structure. In addition, two or more emission units may be disposed to be separated such that the OLED D may have a tandem structure.

As illustrate below, in each of the red pixel region and the green pixel region, the EML includes a compound having a delayed fluorescent property and a compound having a fluorescent property. As a result, the organic light emitting display device 100 has high emitting efficiency and narrow full width at half maximum (FWHM).

The second electrode 230 is formed over the substrate 110 where the light emitting layer 220 is formed. The second electrode 230 covers an entire surface of the display area and may be formed of a conductive material having a relatively low work function to serve as a cathode. For example, the second electrode 230 may be formed of aluminum (Al), magnesium (Mg), calcium (Ca), silver (Ag) or their alloy, e.g., Mg-Ag alloy (MgAg). The second electrode 230 may have a thin profile, e.g., 10 to 30nm, to be transparent (or semi-transparent).

Although not shown, the OLED D may further include a capping layer on the second electrode 230. The emitting efficiency of the OLED D may be further improved by the capping layer.

An encapsulation film (or an encapsulation layer) 170 is formed on the second electrode 230 to prevent penetration of moisture into the OLED D. The encapsulation film 170 includes a first inorganic insulating layer 172, an organic insulating layer 174 and a second inorganic insulating layer 176 sequentially stacked, but it is not limited thereto.

Although not shown, the organic light emitting display device 100 may include a color filter corresponding to the red, green and blue pixel regions. For example, the color filter may be positioned on or over the OLED D or the encapsulation film 170.

In addition, the organic light emitting display device 100 may further include a cover window (not shown) on or over the encapsulation film 170 or the color filter. In this instance, the substrate 110 and the cover window have a flexible property such that a flexible organic light emitting display device may be provided.

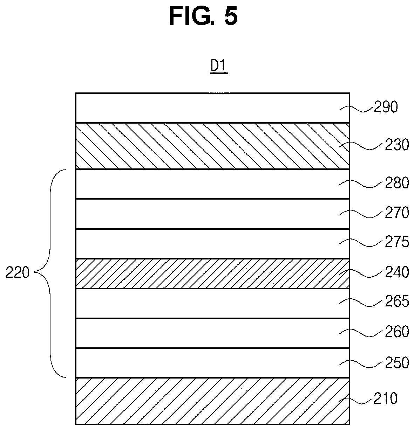

FIG. 5 is a schematic cross-sectional view of an OLED of an organic light emitting display device according to a third embodiment of the present disclosure.

As shown in FIG. 5, the OLED D1 includes the first and second electrodes 210 and 230 facing each other and the light emitting layer 220 therebetween. The light emitting layer 220 includes the EML 240. In addition, the OLED D1 may further include the capping layer 290 for enhancing the light extraction.

The organic light emitting display device may include the red, green and blue pixel regions, and the OLED D1 may be positioned in each of the red, green and blue pixel regions.

The first electrode 210 may be an anode, and the second electrode 230 may be a cathode. The first electrode 210 is a reflection electrode, and the second electrode 230 is a transparent (or semitransparent) electrode. For example, the first electrode 210 may have a structure of ITO/Ag/ITO, and the second electrode 230 may be formed of MgAg.

The light emitting layer 220 may further include at least one of the HTL 260 between the first electrode 210 and the EML 240 and the ETL 270 between the EML 240 and the second electrode 230.

In addition, the light emitting layer 220 may further include at least one of the HIL 250 between the first electrode 210 and the HTL 260 and the EIL 280 between the ETL 270 and the second electrode 230.

Moreover, the light emitting layer 220 may further include at least one of the EBL 265 between the EML 240 and the HTL 260 and the HBL 275 between the EML 240 and the ETL 270.

For example, the HTL 260 may include one of the compounds in Formula 1.

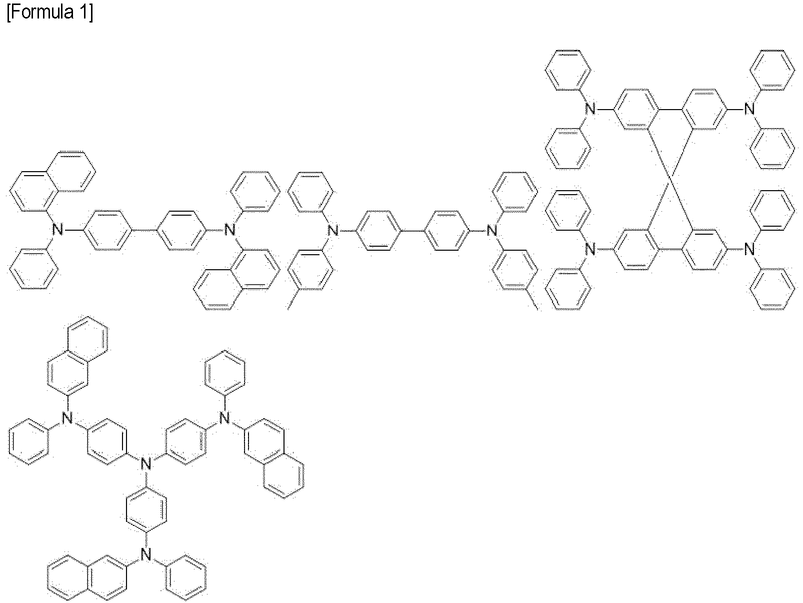

Alternatively, the HTL 260 may include at least one compound selected from the group consisting of N,N'-diphenyl-N,N'-bis(3-methylphenyl)-1,1'-biphenyl-4,4'-diamine (TPD), NPB(NPD), 4,4'-bis(N-carbazolyl)-1,1'-biphenyl (CBP), poly[N,N'-bis(4-butylpnehyl)-N,N'-bis(phenyl)-benzidine] (poly-TPD), (poly[(9,9-dioctylfluorenyl-2,7-diyl)-co-(4,4'-(N-(4-sec-butylphenyl)diphenylamine))] (TFB), di-[4-(N,N-di-p-tolyl-amino)-phenyl]cyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl-4-amine and the compound in Formula 1.

The HIL 250 may be formed the compound in Formula 1 with a compound in Formula 2 as a dopant. In the HIL 250, the compound in Formula 2 may have a weight % of about 1 to 10.

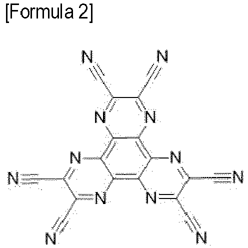

Alternatively, the HIL 250 may include at least one compound selected from the group consisting of 4,4',4"-tris(3-methylphenylamino)triphenylamine (MTDATA), 4,4',4"-tris(N,N-diphenyl-amino)triphenylamine (NATA), 4,4',4"-tris(N-(naphthalene-1-yl)-N-phenyl-amino)triphenylamine (1T-NATA), 4,4',4"-tris(N-(naphthalene-2-yl)-N-phenyl-amino)triphenylamine (2T-NATA), copper phthalocyanine(CuPc), tris(4-carbazoyl-9-yl-phenyl)amine (TCTA), N,N'-diphenyl-N,N'-bis(1-naphthyl)-1,1'-biphenyl-4,4"-diamine (NPB or NPD), 1,4,5,8,9,11-hexaazatriphenylenehexacarbonitrile (dipyrazino[2,3-f:2'3'-h]quinoxaline-2,3,6,7,10,11-hexacarbonitrile (HAT-CN)), 1,3,5-tris[4-(diphenylamino)phenyl]benzene (TDAPB), poly(3,4-ethylenedioxythiphene)polystyrene sulfonate (PEDOT/PSS), and N-(biphenyl-4-yl)-9,9-dimethyl-N-(4-(9-phenyl-9H-carbazol-3-yl)phenyl)-9H-fluoren-2-amine.

The ETL 270 may include one of the compounds in Formula 3.

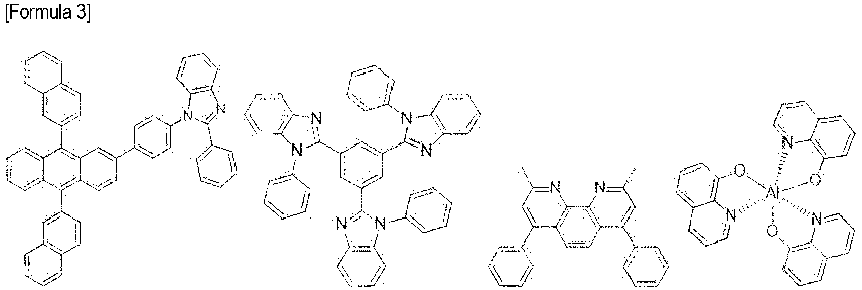

Alternatively, the ETL 270 may include one of an oxadiazole-based compound, a triazole-based compound, a phenanthroline-based compound, a benzoxazole-based compound, a benzothiazole-based compound, a benzimidazole-based compound and a triazine-based compound. For example, the ETL 270 may include at least one compound selected from the group consisting of tris-(8-hydroxyquinoline aluminum (Alq₃), 2-biphenyl-4-yl-5-(4-t-butylphenyl)-1,3,4-oxadiazole (PBD), spiro-PBD, lithium quinolate (Liq), 1,3,5-tris(N-phenylbenzimidazol-2-yl)benzene (TPBi), bis(2-methyl-8-quinolinolato-N1,O8)-(1,1'-biphenyl-4-olato)aluminum (BAlq), 4,7-diphenyl-1,10-phenanthroline (Bphen), 2,9-bis(naphthalene-2-yl)-4,7-diphenyl-1,10-phenanthroline (NBphen), 2,9-dimethyl-4,7-diphenyl-1,10-phenathroline (BCP), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), 1,3,5-tri(p-pyrid-3-yl-phenyl)benzene (TpPyPB), 2,4,6-tris(3'-(pyridin-3-yl)biphenyl-3-yl)1,3,5-triazine (TmPPPyTz), Poly[9,9-bis(3'-((N,N-dimethyl)-N-ethylammonium)-propyl)-2,7-fluorene]-alt-2,7-(9,9-dioctylfluorene)] (PFNBr), tris(phenylquinoxaline) (TPQ), and diphenyl-4-triphenylsilyl-phenylphosphine oxide (TSPO1).

The EIL 280 may include at least one of an alkali halide compound, such as LiF, CsF, NaF, or BaF₂, but it is not limited thereto.

The EBL 265, which is positioned between the HTL 260 and the EML 240 to block the electron transfer from the EML 240 to the HTL 260, may include a compound in Formula 4.

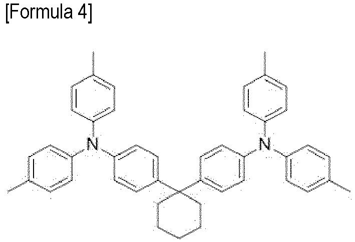

Alternatively, the EBL 265 may include at least one compound selected from the group consisting of TCTA, tris[4-(diethylamino)phenyl]amine, N-(biphenyl-4-yl)-9,9-dimethyl-N-(4-(9-phenyl-9H-carbazol-3-yl)phenyl)-9H-fluoren-2-amine, TAPC, MTDATA, 1,3-bis(carbazol-9-yl)benzene (mCP), 3,3'-bis(N-carbazolyl)-1,1'-biphenyl (mCBP), CuPc, N,N'-bis[4-[bis(3-methylphenyl)amino]phenyl]-N,N'-diphenyl-[1,1'-biphenyl]-4,4'-diamine (DNTPD), TDAPB, DCDPA, 2,8-bis(9-phenyl-9H-carbazol-3-yl)dibenzo[b,d]thiophene) and the compound in Formula 4.

The HBL 275, which is positioned between the ETL 270 and the EML 240 to block the hole transfer from the EML 240 to the ETL 270, may include a compound in Formula 5.

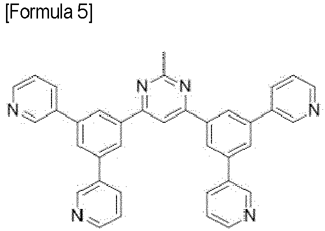

Alternatively, the EBL 265 may include at least one compound selected from the group consisting of BCP, BAlq, Alq3, PBD, spiro-PBD, Liq, bis-4,6-(3,5-di-3-pyridylphenyl)-2-methylpyrimidine (B3PYMPM), bis[2-(diphenylphosphino)phenyl]ether oxide (DPEPO), 9-(6-9H-carbazol-9-yl)pyridine-3-yl)-9H-3,9'-bicarbazole, TSPO1 and the compound in Formula 5.

The capping layer is positioned on or over the second electrode 230 and may include one of the compounds in Formula 1.

In the first pixel region P1, i.e., the red pixel region, the EML 240 includes a first compound as a host, a second compound being a delayed fluorescent material (or compound) and a third compound being a fluorescent material. The second compound may be an auxiliary host or an auxiliary dopant, and the third compound may be an emitter (or a dopant).

The lowest unoccupied molecular orbital (LUMO) energy level of the second compound is equal to or lower than -3.0eV. In addition, a difference between the highest occupied molecular orbital (HOMO) of the first compound and the HOMO energy level of the second compound is equal to or less than 0.4eV. Moreover, a difference between the LUMO energy level of the second compound and the LUMO energy level of the third compound is equal to or less than 0.3eV. The energy band gap of the third compound has a range of 1.8 to 2.2eV. Various methods of determining the HOMO energy level are known to the skilled person. For example, the HOMO energy level can be determined using a conventional surface analyser such as an AC3 surface analyser made by RKI instruments. The surface analyser may be used to interrogate a single film (neat film) of a compound with a thickness of 50 nm. The LUMO energy level can be calculated as follows: LUMO = HOMO-bandgap. The bandgap may be calculated using any conventional method known to the skilled person, such as from a UV-vis measurement of a single film with a thickness of 50 nm. For example, this can be done using a SCINCO S-3100 spectrophotometer. The HOMO and LUMO values of the compounds of the examples and embodiments disclosed herein may be determined in this way. Namely, the HOMO and LUMO values may be experimentally or empirically determined values of thin films, such as 50 nm films.

In the second pixel region P2, i.e., the green pixel region, the EML 240 includes a fourth compound as a host, a fifth compound being a delayed fluorescent material (or compound) and a sixth compound being a fluorescent material. The fifth compound may be an auxiliary host or an auxiliary dopant, and the sixth compound may be an emitter (or a dopant).

The LUMO energy level of the fifth compound is equal to or lower than -3.0eV. In addition, a difference between the HOMO of the fourth compound and the HOMO energy level of the fifth compound is equal to or less than 0.4eV. Moreover, a difference between the LUMO energy level of the fifth compound and the LUMO energy level of the sixth compound is equal to or less than 0.3eV. The energy band gap of the sixth compound has a range of 2.2 to 2.4eV.

Each of the first compound the fourth compound is represented by Formula 6-1.

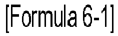

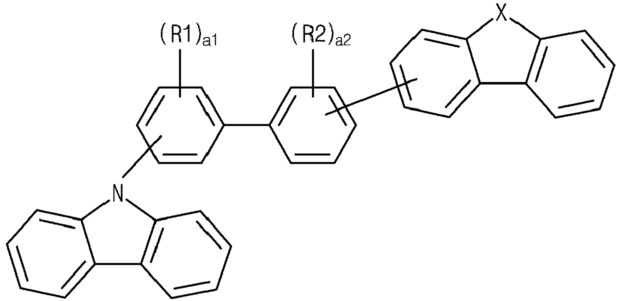

In Formula 6-1, each of a1 and a2 is independently an integer of 0 to 4. Each of R1 and R2 is independently selected from the group consisting of deuterium and a substituted or unsubstituted C1 to C10 alkyl group, or adjacent R1 and R2 is connected to each other to form a ring including O or S. X is selected from the group consisting of O, S and NR3, and R3 is selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group.

For example, R3 may be a C6 to C30 aryl group, e.g., phenyl.

Namely, the first compound as a host of the EML 240 in the first pixel region P1, i.e., the red pixel region and the fourth compound as a host of the EML 240 in the second pixel region P2, i.e., the green pixel region have the same chemical structure and may be the same or different.

In the present disclosure, the C6 to C30 aryl group (or C6 to C30 arylene group) may be selected from the group consisting of phenyl, biphenyl, terphenyl, naphthyl, anthracenyl, pentanenyl, indenyl, indenoindenyl, heptalenyl, biphenylenyl, indacenyl, phenanthrenyl, benzophenanthrenyl, dibenzophenanthrenyl, azulenyl, pyrenyl, fluoranthenyl, triphenylenyl, chrysenyl, tetraphenyl, tetrasenyl, picenyl, pentaphenyl, pentacenyl, fluorenyl, indenofluorenyl and spiro-fluorenyl.

In the present disclosure, the C5 to C30 heteroaryl group may be selected from the group consisting of pyrrolyl, pyridinyl, pyrimidinyl, pyrazinyl, pyridazinyl, triazinyl, tetrazinyl, imidazolyl, pyrazolyl, indolyl, isoindolyl, indazolyl, indolizinyl, pyrrolizinyl, carbazolyl, benzocarbazolyl, dibenzocarbazolyl, indolocarbazolyl, indenocarbazolyl, benzofurocarbazolyl, benzothienocarbazolyl, quinolinyl, isoquinolinyl, phthalazinyl, quinoxalinyl, cinnolinyl, quinazolinyl, quinozolinyl, quinolinyl, purinyl, phthalazinyl, quinoxalinyl, benzoquinolinyl, benzoisoquinolinyl, benzoquinazolinyl, benzoquinoxalinyl, acridinyl, phenanthrolinyl, perimidinyl, phenanthridinyl, pteridinyl, cinnolinyl, naphtharidinyl, furanyl, oxazinyl, oxazolyl, oxadiazolyl, triazolyl, dioxynyl, benzofuranyl, dibenzofuranyl, thiopyranyl, xanthenyl, chromanyl, isochromanyl, thioazinyl, thiophenyl, benzothiophenyl, dibenzothiophenyl, difuropyrazinyl, benzofurodibenzofuranyl, benzothienobenzothiophenyl, benzothienodibenzothiophenyl, benzothienobenzofuranyl, and benzothienodibenzofuranyl.

In the present disclosure, without specific definition, when at least one of a C1 to C10 alkyl group, a C6 to C30 aryl group and a C5 to C30 heteroaryl group is substituted, a substituent may be at least one of deuterium, tritium, cyano, halogen, a C1 to C10 alkyl group, a C1 to C10 alkoxy group and a C6 to C30 aryl group.

For the first compound as a host of the EML 240 in the first pixel region P1, i.e., the red pixel region, Formula 6-1 may be represented by Formula 6-2.

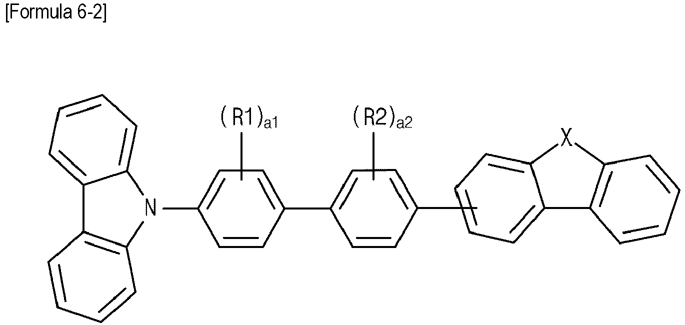

In Formula 6-2, the definitions of R1, R2, X, a1 and a2 are same as those in Formula 6-1.

For the fourth compound as a host of the EML 240 in the second pixel region P2, i.e., the green pixel region, Formula 6-1 may be represented by Formula 6-3.

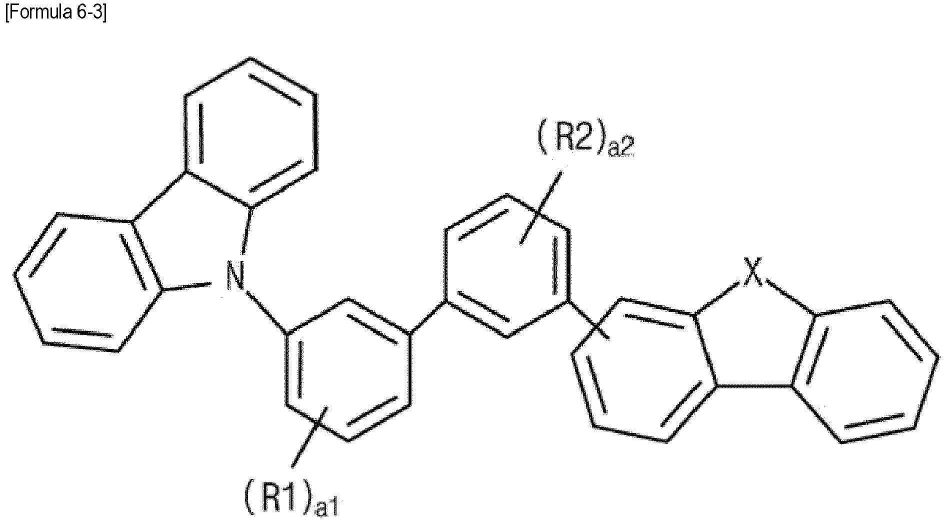

In Formula 6-3, the definitions of R1, R2, X, a1 and a2 are same as those in Formula 6-1.

Namely, the first compound of the EML 240 in the first pixel region P1, i.e., the red pixel region, and the fourth compound of the EML 240 in the second pixel region P2, i.e., the green pixel region, may have a difference in a linking (connecting, combining or joining) position of two heteroaryl groups to a linker, i.e., biphenyl, dibenzofuranyl or dibenzothiophenyl. In other words, in the first compound of the EML 240 in the first pixel region P1, i.e., the red pixel region, the linker and two heteroaryl groups are linked to the liker in a para-position, while in the fourth compound of the EML 240 in the second pixel region P2, i.e., the green pixel region, the linker and two heteroaryl groups are linked to the liker in a meta-position.

Each of the first and fourth compounds is independently one of the compounds in Formula 6-4.

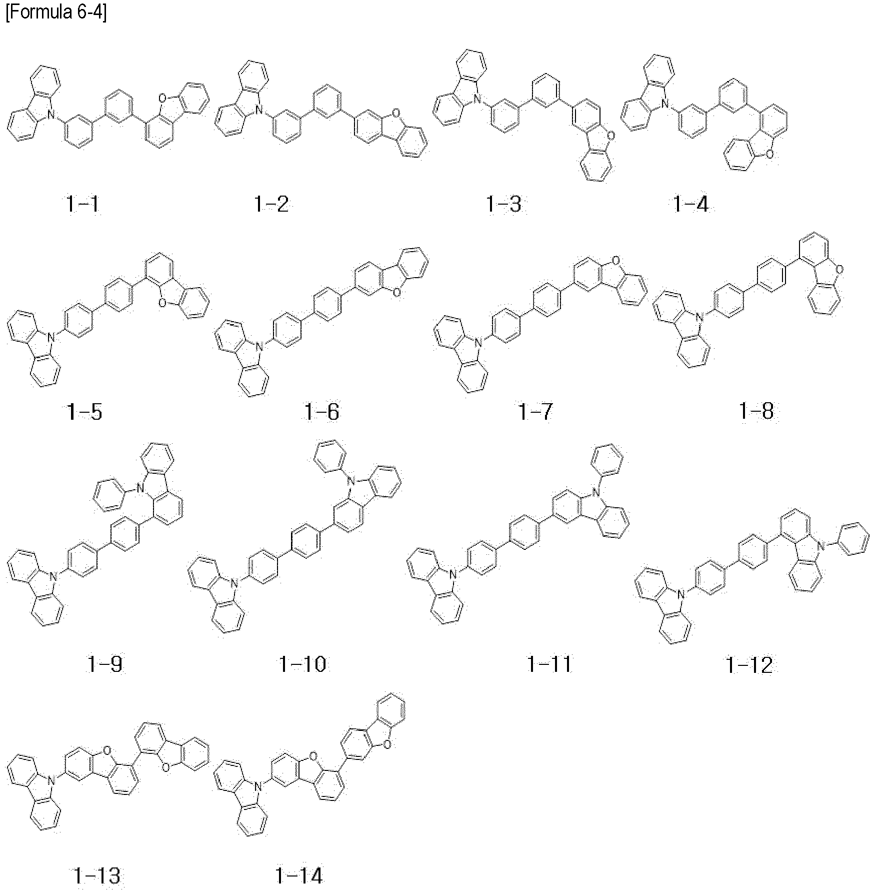

For example, the first compound may be one of the compounds 1-5 to 1-12, and the fourth compound may be one of the compounds 1-1 to 1-4, 1-13 and 1-14.

Each of the second and fifth compound is represented by Formula 7-1.

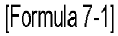

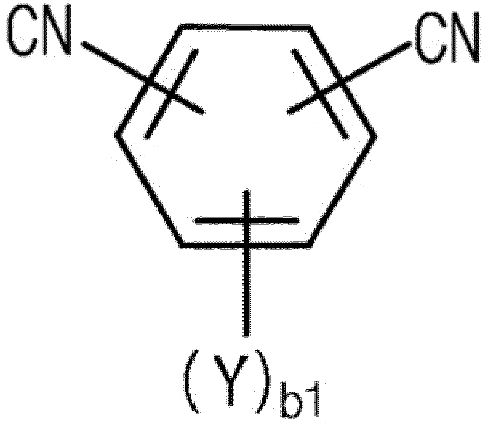

In Formula 7-1, Y is represented by Formula 7-2, and b1 is an integer of 0 to 4. When b is two or more, two or more Ys may be the same or different.

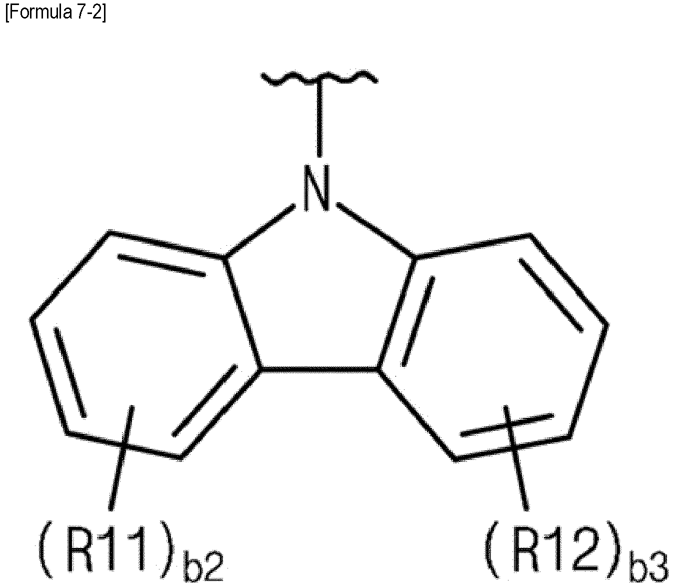

In Formula 7-2, each of R11 and R12 is independently selected from the group consisting of deuterium, a substituted or unsubstituted C1 to C10 alkyl group, a substituted or unsubstituted C6 to C30 aryl group and a substituted or unsubstituted C5 to C30 heteroaryl group, and each of b2 and b3 is independently an integer of 0 to 4.

For example, b1 may be 3 or 4, preferably 4. Each of b2 and b3 may be independently 0 or 1. Each of R11 and R12 may be independently selected from a C1 to C10 alkyl group, e.g., methyl, and a C5 to C30 heteroaryl group, e.g., carbazolyl.

Namely, the second compound as an auxiliary dopant of the EML 240 in the first pixel region P1, i.e., the red pixel region and the fifth compound as an auxiliary dopant of the EML 240 in the second pixel region P2, i.e., the green pixel region have the same chemical structure and may be the same or different.

For the second compound as an auxiliary dopant of the EML 240 in the first pixel region P1, i.e., the red pixel region, Formula 7-1 may be represented by Formula 8-1.

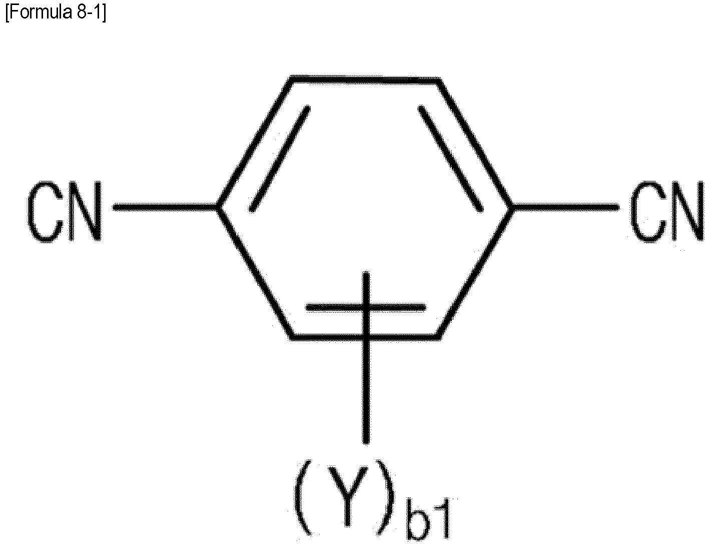

In Formula 8-1, Y is represented by Formula 7-2, and the definition of b1 is the same as that in Formula 7-1.

For the fifth compound as an auxiliary dopant of the EML 240 in the second pixel region P2, i.e., the green pixel region, Formula 7-1 may be represented by Formula 8-2.

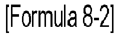

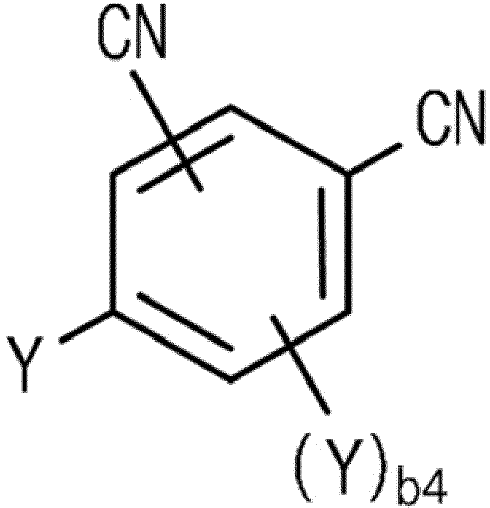

In Formula 8-2, Y is represented by Formula 7-2, and b4 is an integer of 0 to 3. For example, b4 may be 2 or 3, and two cyano groups may be connected in an ortho-position.

Namely, the second compound of the EML 240 in the first pixel region P1, i.e., the red pixel region, and the fifth compound of the EML 240 in the second pixel region P2, i.e., the green pixel region, may have a difference in a linking position of two cyano groups to a phenylene group. In other words, in the second compound of the EML 240 in the first pixel region P1, i.e., the red pixel region, two cyano groups are linked to the phenylene group in a para-position, while in the fifth compound of the EML 240 in the second pixel region P2, i.e., the green pixel region, two cyano groups are linked to the phenylene group in a meta-position.

Each of the second and fifth compounds is independently one of the compounds in Formula 8-3.

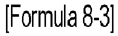

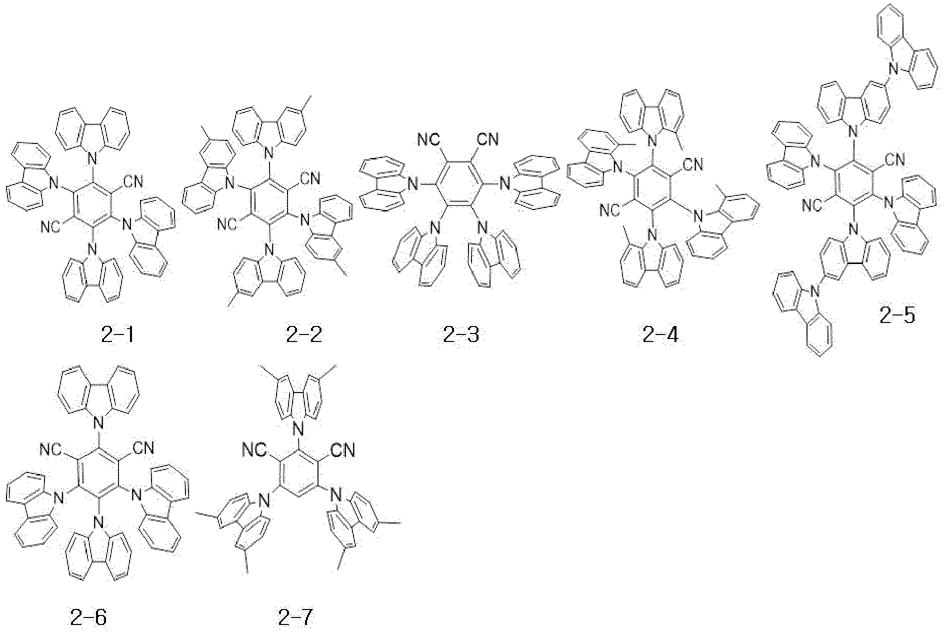

For example, the second compound may be one of the compounds 2-1, 2-2, 2-4 and 2-5, and the fifth compound may be one of the compounds 2-3, 2-6 and 2-7.

The third compound is represented by Formula 9-1.

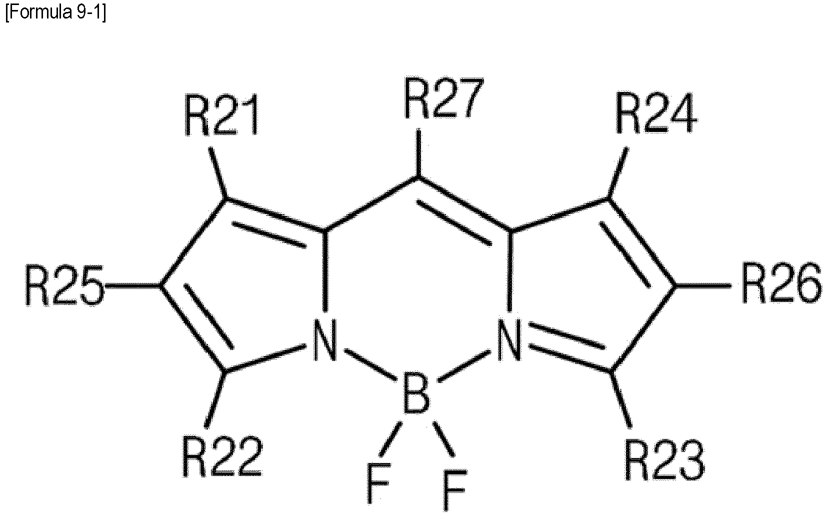

In Formula 9-1, each of R21, R22, R23 and R24 is independently a substituted or unsubstituted C6 to C30 aryl group, and each of R25, R26 and R27 is independently selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group.

For example, each of R21, R22, R23 and R24 may be independently phenyl unsubstituted or substituted with a C1 to C10 alkyl group, e.g., methyl or tert-butyl. In addition, R25 and R26 may be hydrogen, and R27 may be selected from a C6 to C30 aryl group, e.g., phenyl, substituted with a C1 to C10 alkoxy group, e.g., methoxy, or a C6 to C30 aryl group, e.g., tert-butyl phenyl, and a C5 to C30 heteroaryl group, e.g., dibenzofuranyl or carbazolyl.

The third compound may be one of the compounds in Formula 9-2.

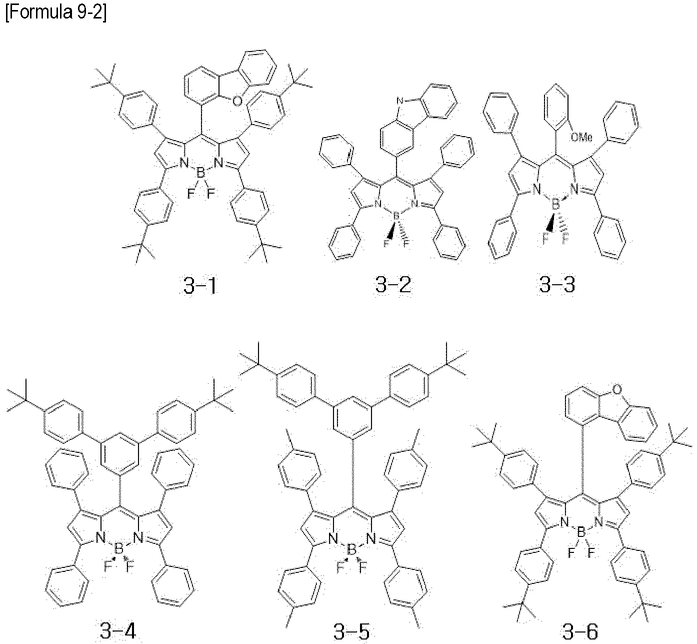

The sixth compound is represented by Formula 10-1.

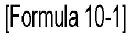

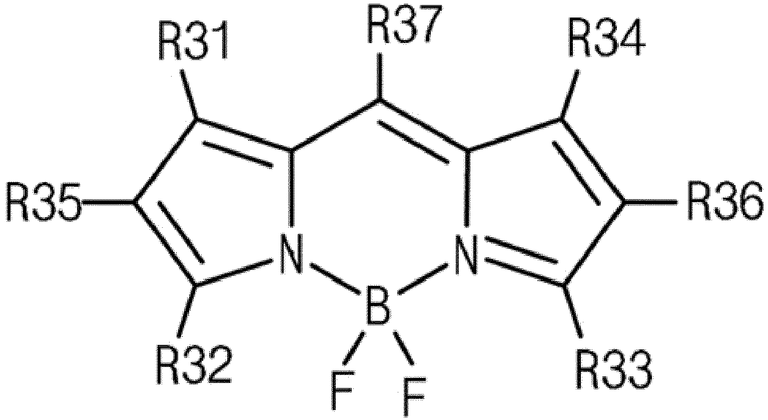

In Formula 10-1, each of R31, R32, R33 and R34 is independently selected from the group consisting of hydrogen and a substituted or unsubstituted C1 to C10 alkyl group, and at least one of R31, R32, R33 and R34 is a substituted or unsubstituted C1 to C10 alkyl group. Each of R35, R36 and R37 is independently selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group.

For example, two or four of R31, R32, R33 and R34 may be a C1 to C10 alkyl group, e.g., methyl. Each of R35 and R36 may be independently selected from hydrogen and a C1 to C10 alkyl group, e.g., ethyl, and R37 may be selected from a C6 to C30 aryl group, e.g., phenyl, unsubstituted or substituted with a C1 to C10 alkyl group, e.g., methyl, or a C6 to C30 aryl group, e.g., tert-butyl phenyl, and a C5 to C30 heteroaryl, e.g., dibenzofuranyl.

The sixth compound may be one of the compounds in Formula 10-2.

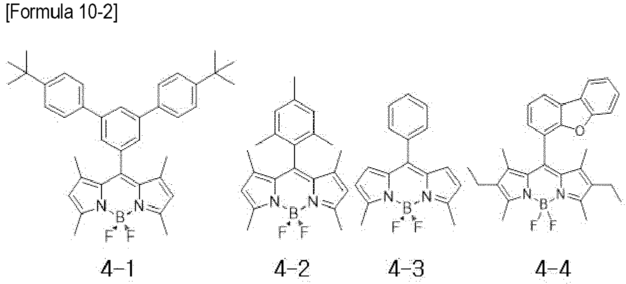

In the EML 240 in the first pixel region P1, i.e., the red pixel region, a weight % of the second compound may be smaller than that of the first compound and may be greater than that of the third compound. For example, in the EML 240 in the first pixel region P1, the first compound may have a weight % of 45 to 55, the second compound may have a weight % of 40 to 50, and the third compound may have a weight % of 0.1 to 5.

In the EML 240 in the second pixel region P2, i.e., the green pixel region, a weight % of the fifth compound may be smaller than that of the fourth compound and may be greater than that of the sixth compound. For example, in the EML 240 in the second pixel region P2, each of the fourth and fifth compounds may have a weight % of 45 to 50, and the sixth compound may have a weight % of 0.1 to 5.

The weight % of the third compound in the EML 240 in the first pixel region P1 may be equal to or greater than that of the sixth compound in the EML 240 in the second pixel region P2.

In the third pixel region P2, i.e., the blue pixel region, the EML 240 includes a seventh compound as a host and an eighth compound being a fluorescent material. The eighth compound may be an emitter (or a dopant).

The seventh compound may be an anthracene derivative. For example, the seventh compound is one of the compounds in Formula 11.

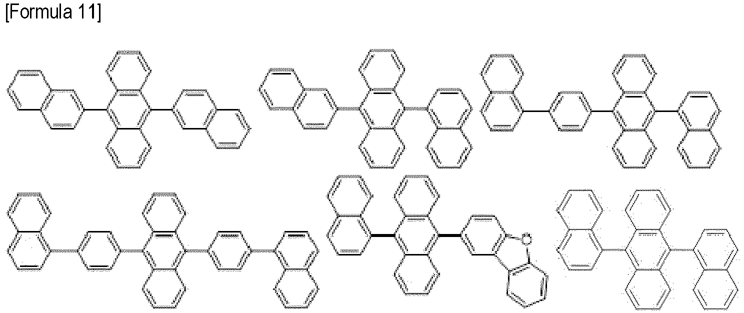

The eighth compound may be a pyrene derivative. For example, the eighth compound is one of the compounds in Formula 12.

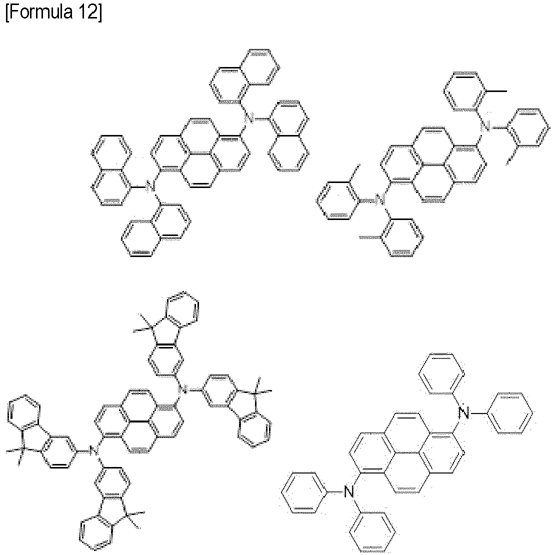

In the OLED D1 of the present disclosure, since each of the EML 240 in the first pixel region P1 and the EML 240 in the second pixel region P2 includes a delayed fluorescent material, which has high emitting efficiency, as the second and fifth compounds and a fluorescent material, which has narrow FWHM, as the third and sixth compounds, the OLED D1 provides hyper-fluorescence.

The hole from the first electrode 210 as an anode and the electron from the second electrode 230 as a cathode are combined in the first compound to generate an exciton, and the exciton is transferred into the second compound. In the second compound, the triplet exciton is converted into the singlet exciton. The singlet exciton of the second compound is transferred into the third compound, and the emission is provided from the third compound. As a result, the OLED D1 can provide narrow FWHM and high emitting efficiency.

### [OLED1]

An anode, an HIL (the compound in Formula 12-1 and the compound in Formula 2 (8wt%), 10nm), an HTL (the compound in Formula 12-1, 70nm), an EBL (the compound in Formula 4, 10nm), an EML (45nm), an HBL (the compound in Formula 5, 10nm), an ETL (the compound in Formula 12-2, 25nm), an EIL (LiF, 5nm), a cathode (Al, 80nm) and a capping layer (the compound in Formula 12-3, 100nm) are sequentially deposited to form an OLED in the red pixel region.

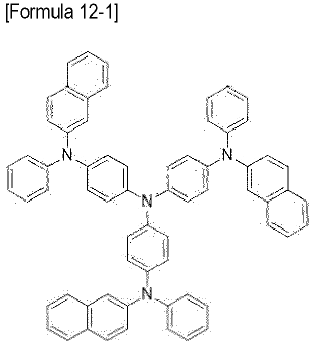

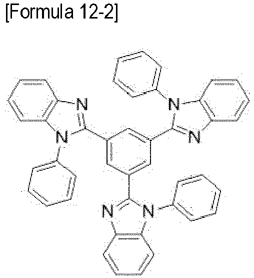

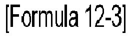

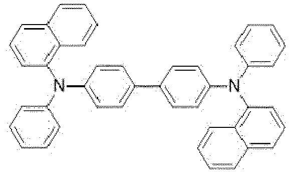

### 1. Comparative Examples

### (1) Comparative Example 1 (Ref1)

The compound 6-1 in Formula 13 (50 wt%), the compound 5-1 in Formula 14 (49.5 wt%) and the compound 3-1 in Formula 9-2 (0.5 wt%) are used to form the EML.

### (2) Comparative Example 2 (Ref2)

The compound 6-1 in Formula 13 (50 wt%), the compound 5-2 in Formula 14 (49.5 wt%) and the compound 3-1 in Formula 9-2 (0.5 wt%) are used to form the EML.

### (3) Comparative Example 3 (Ref3)

The compound 6-1 in Formula 13 (50 wt%), the compound 2-1 in Formula 8-3 (49.5 wt%) and the compound 3-1 in Formula 9-2 (0.5 wt%) are used to form the EML.

### (4) Comparative Example 4 (Ref4)

The compound 6-1 in Formula 13 (50 wt%), the compound 2-2 in Formula 8-3 (49.5 wt%) and the compound 3-1 in Formula 9-2 (0.5 wt%) are used to form the EML.

### (5) Comparative Example 5 (Ref5)

The compound 6-2 in Formula 13 (50 wt%), the compound 2-1 in Formula 8-3 (49.5 wt%) and the compound 3-1 in Formula 9-2 (0.5 wt%) are used to form the EML.

### (6) Comparative Example 6 (Ref6)

The compound 1-5 in Formula 6-4 (50 wt%), the compound 5-1 in Formula 14 (49.5 wt%) and the compound 3-1 in Formula 9-2 (0.5 wt%) are used to form the EML.

### 2. Examples

### (1) Example 1 (Ex1)

The compound 1-1 in Formula 6-4 (50 wt%), the compound 2-1 in Formula 8-3 (49.5 wt%) and the compound 3-1 in Formula 9-2 (0.5 wt%) are used to form the EML.

### (2) Example 2 (Ex2)

The compound 1-13 in Formula 6-4 (50 wt%), the compound 2-1 in Formula 8-3 (49.5 wt%) and the compound 3-1 in Formula 9-2 (0.5 wt%) are used to form the EML.

### (3) Example 3 (Ex3)

The compound 1-7 in Formula 6-4 (50 wt%), the compound 2-1 in Formula 8-3 (49.5 wt%) and the compound 3-1 in Formula 9-2 (0.5 wt%) are used to form the EML.

### (4) Example 4 (Ex4)

The compound 1-5 in Formula 6-4 (50 wt%), the compound 2-1 in Formula 8-3 (49.5 wt%) and the compound 3-1 in Formula 9-2 (0.5 wt%) are used to form the EML.

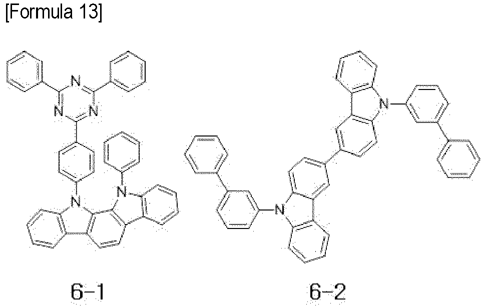

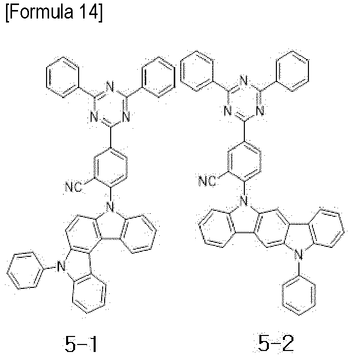

The emitting properties, i.e., the driving voltage (V), the external quantum efficiency (EQE), the maximum emission wavelength (ELmax) and the FWHM, of the OLED in Comparative Examples 1 to 6 and Examples 1 to 4 are measured and listed in Table 1.

**Table 1**

| | Host (50wt%) | TADF (49.5wt%) | FD (0.5wt%) | Voltage (V) | EQE (%) | ELmax (nm) | FWHM (nm) |
|---|---|---|---|---|---|---|---|
| Ref1 | 6-1 | 5-1 | 3-1 | 4.19 | 5.3 | 618 | 47 |
| Ref2 | 6-1 | 5-2 | 3-1 | 4.14 | 6.0 | 618 | 48 |
| Ref3 | 6-1 | 2-1 | 3-1 | 3.80 | 10.5 | 620 | 40 |
| Ref4 | 6-1 | 2-2 | 3-1 | 4.00 | 9.9 | 620 | 41 |
| Ref5 | 6-2 | 2-1 | 3-1 | 4.36 | 7.1 | 620 | 44 |
| Ref6 | 1-5 | 5-1 | 3-1 | 4.37 | 6.5 | 624 | 48 |
| Ex1 | 1-1 | 2-1 | 3-1 | 5.83 | 16.0 | 622 | 42 |
| Ex2 | 1-13 | 2-1 | 3-1 | 5.26 | 17.2 | 618 | 42 |
| Ex3 | 1-7 | 2-1 | 3-1 | 3.99 | 15.5 | 620 | 40 |
| Ex4 | 1-5 | 2-1 | 3-1 | 4.09 | 16.7 | 620 | 41 |

As shown in Table 1, in comparison to the OLEDs of Ref1 to Ref6, the OLEDs of Ex1 to Ex4, which include the first compound with Formula 6-1, the second compound with Formula 7-1 and the third compound with Formula 9-1 in the red EML, have advantages in at least one of the driving voltage, the emitting efficiency (EQE) and the FWHM.

Namely, since the compounds used in Ref1 to Ref6 do not satisfy the above condition required for the first to third compounds included in the red EML, the property or the display quality performance of the OLED is degraded.

However, in the OLED of the present disclosure, since the first to third compounds in the red EML satisfy the above conditions, the energy from the first compound is efficiently transferred into the third compound through the second compound so that the emission is provided from the third compound. As a result, the property or the display quality performance of the OLED is improved.

In addition, in comparison to the OLED of Ex1 and Ex2, which includes the first compound represented by Formula 6-3, i.e., the compound 1-1 and the compound 1-13, the driving voltage of the OLED of Ex3 and Ex4, which includes the first compound represented by Formula 6-2, i.e., the compound 1-7 and the compound 1-5, is significantly decreased.

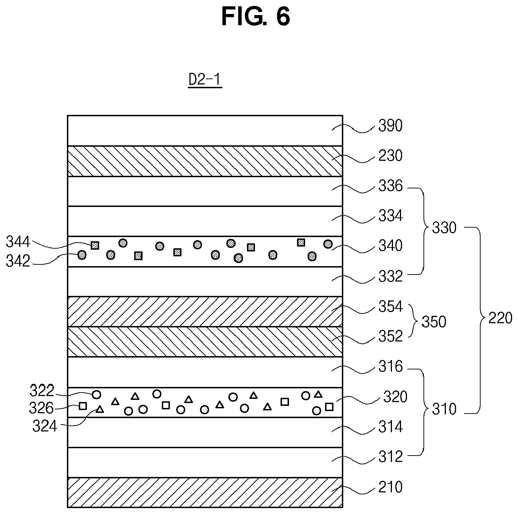

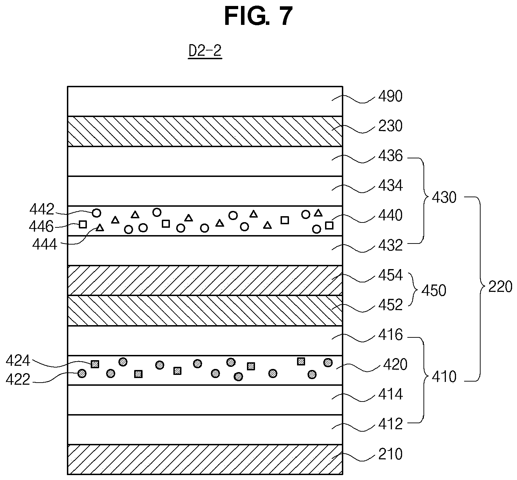

FIG. 6 is a schematic cross-sectional view of an OLED in a red pixel region of an organic light emitting display device according to a fourth embodiment of the present disclosure, and FIG. 7 is a schematic cross-sectional view of an OLED in a green pixel region of an organic light emitting display device according to the fourth embodiment of the present disclosure.

As shown in FIG. 6, the OLED D2-1 includes the first electrode 210 as a reflection electrode, the second electrode 230 as a transparent (or semitransparent) electrode facing the first electrode 210 and the light emitting layer 220 positioned between the first and second electrodes 210 and 230. The light emitting layer 220 includes a first emitting part 310 including a first EML 320, which is a fluorescent emitting layer, and a second emitting part 330 including a second EML 340, which is a phosphorescent emitting layer. The second emitting part 330 is positioned between the first emitting part 310 and the second electrode 230. The light emitting layer 220 may further include a charge generation layer (CGL) between the first and second emitting parts 310 and 330. In addition, the OLED D2-1 may further include a capping layer 390 for enhancing the light extraction positioned on or over the second electrode 230 as the transparent electrode.

The organic light emitting display device 100 may include a red pixel region, a green pixel region and a blue pixel region, and the OLED D2-1 is positioned in the first pixel region P1 being the red pixel region.

The first electrode 210 may be an anode, and the second electrode 230 may be a cathode.

The first electrode 210 may have a structure of ITO/Ag/ITO, and the second electrode 230 may be formed of MgAg. Alternatively, the first electrode 210 may have a single-layered structure of the ITO layer, and the second electrode 230 may be a reflection electrode. In this instance, the second emitting part 330 including the second EML 340, which is a phosphorescent emitting layer, is positioned to be closer to the first electrode 210, and the first emitting part 310 including the first EML 320, which is a fluorescent emitting layer, is positioned to be closer to the second electrode 230.

Namely, in the OLED D2-1 in the first pixel region P1, i.e., the red pixel region, the second EML 340 being the phosphorescent emitting layer is positioned at a side of the transparent electrode, i.e., a side of a display surface, and the first EML 320 being the fluorescent emitting layer is positioned at a side of the reflection electrode. In other words, the first EML 320 being the fluorescent emitting layer is positioned between the reflection electrode and the second EML 340 being the phosphorescent emitting layer, and the second EML 340 being the phosphorescent emitting layer is positioned between the transparent electrode and the first EML 320 being the fluorescent emitting layer.

The first emitting part 310 may further include at least one of an HIL 312 under the first EML 320, a first HTL 314 between the HIL 312 and the first EML 320 and a first ETL 316 on the first EML 320.

The first EML 320 includes a first compound 322 represented by Formula 6-1, a second compound 324 represented by Formula 7-1 and a third compound 326 represented by Formula 9-1. The first compound 322 may act as a host, the second compound 324 may act as an auxiliary dopant (or an auxiliary host), and the third compound 326 may act as an emitter. Namely, as mentioned above, the first EML 320 is a fluorescent emitting layer, where the light emission is provided from the third compound 326.

For example, the first compound 322 may be represented by Formula 6-2, the second compound 324 may be represented by Formula 8-1, and the third compound 326 may be represented by Formula 9-1. The first compound 322 may be one of the compounds in Formula 6-4, the second compound 324 may be one of the compounds in Formula 8-3, and the third compound 326 may be one of the compounds in Formula 9-2.

In the first EML 320, a weight % of the second compound 324 may be smaller than that of the first compound 322 and may be greater than that of the third compound 326. For example, in the first EML 320, the first compound 322 may have a weight % of 45 to 55, the second compound 324 may have a weight % of 40 to 50, and the third compound 326 may have a weight % of 0.1 to 5.

The second emitting part 330 may further include at least one of a second HTL 332 under the second EML 340, an EIL 336 over the second EML 340 and a second ETL 334 between the second EML 340 and the EIL 336.

The second EML 340 includes a first host 342 and a red phosphorescent dopant (emitter) 344. The first host 342 may have a weight % being greater than the red phosphorescent dopant 344. For example, the red phosphorescent dopant 344 may have a weight % of 0.1 to 5 with respect to the first host 342.

The first host 342 may be a compound in Formula 15.

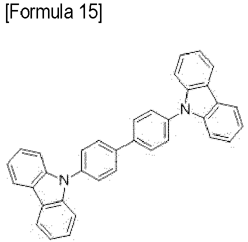

The red phosphorescent dopant 344 may be one of the compounds in Formula 16.

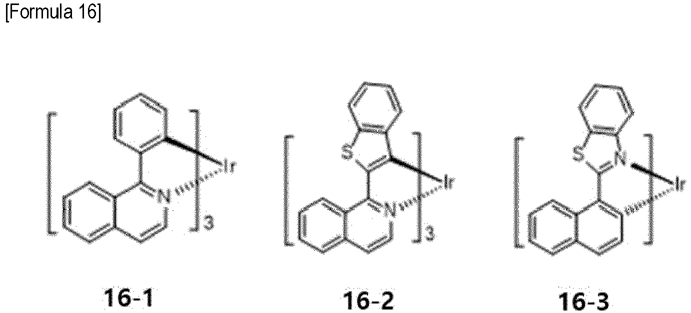

The CGL 350 is positioned between the first and second emitting parts 310 and 330. Namely, the first and second emitting parts 310 and 330 are connected through the CGL 350. The CGL 350 may be a P-N junction type CGL of an N-type CGL 352 and a P-type CGL 354.

The N-type CGL 352 is positioned between the first ETL 316 and the second HTL 332, and the P-type CGL 354 is positioned between the N-type CGL 352 and the second HTL 332. The N-type CGL 352 provides an electron into the first EML 320 of the first emitting part 310, and the P-type CGL 354 provides a hole into the second EML 340 of the second emitting part 330.

The N-type CGL 352 may include the compound of Formula 3 and Li as a dopant. In the N-type CGL 352, Li may have a weight % of 1 to 10.

The P-type CGL 354 may include the compound in Formula 1 and the compound in Formula 2 as a dopant. In the P-type CGL 354, the compound in Formula 2 may have a weight % of 1 to 10.

As shown in FIG. 7, the OLED D2-2 includes the first electrode 210 as a reflection electrode, the second electrode 230 as a transparent (or semitransparent) electrode facing the first electrode 210 and the light emitting layer 220 positioned between the first and second electrodes 210 and 230. The light emitting layer 220 includes a first emitting part 410 including a first EML 420, which is a phosphorescent emitting layer, and a second emitting part 430 including a second EML 440, which is a fluorescent emitting layer. The second emitting part 430 is positioned between the first emitting part 410 and the second electrode 230. The light emitting layer 220 may further include a charge generation layer (CGL) between the first and second emitting parts 410 and 430. In addition, the OLED D2-2 may further include a capping layer 390 for enhancing the light extraction positioned on or over the second electrode 230 as the transparent electrode. The capping layer 390 in the OLED D2-1 and the capping layer 390 in the OLED D2-2 may be formed as one-body to be continuous.

The organic light emitting display device 100 may include a red pixel region, a green pixel region and a blue pixel region, and the OLED D2-2 is positioned in the second pixel region P2 being the green pixel region.

The first electrode 210 may be an anode, and the second electrode 230 may be a cathode.

The first electrode 210 may have a structure of ITO/Ag/ITO, and the second electrode 230 may be formed of MgAg. Alternatively, the first electrode 210 may have a single-layered structure of the ITO layer, and the second electrode 230 may be a reflection electrode. In this instance, the second emitting part 430 including the second EML 440, which is a fluorescent emitting layer, is positioned to be closer to the first electrode 210, and the first emitting part 410 including the first EML 420, which is a phosphorescent emitting layer, is positioned to be closer to the second electrode 230.

Namely, in the OLED D2-2 in the second pixel region P2, i.e., the green pixel region, the second EML 440 being the fluorescent emitting layer is positioned at a side of the transparent electrode, i.e., a side of a display surface, and the first EML 420 being the phosphorescent emitting layer is positioned at a side of the reflection electrode. In other words, the first EML 420 being the phosphorescent emitting layer is positioned between the reflection electrode and the second EML 440 being the fluorescent emitting layer, and the second EML 440 being the fluorescent emitting layer is positioned between the transparent electrode and the first EML 420 being the phosphorescent emitting layer.

The first emitting part 410 may further include at least one of an HIL 412 under the first EML 420, a first HTL 414 between the HIL 412 and the first EML 420 and a first ETL 416 on the first EML 420.

The first EML 420 includes a second host 422 and a green phosphorescent dopant (emitter) 424. The second host 422 may have a weight % being greater than the green phosphorescent dopant 424. For example, the green phosphorescent dopant 424 may have a weight % of 0.1 to 5 with respect to the second host 422.

The second host 422 is a compound in Formula 17.

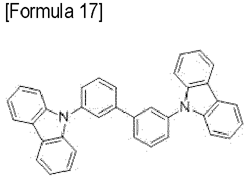

The green phosphorescent dopant 424 is one of the compounds in Formula 18.

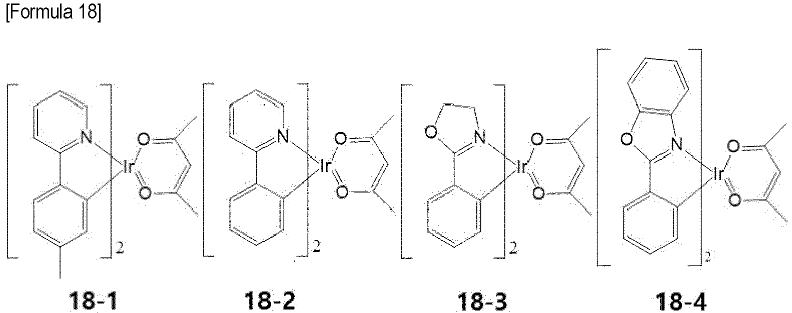

The second emitting part 430 may further include at least one of a second HTL 432 under the second EML 440, an EIL 436 over the second EML 440 and a second ETL 434 between the second EML 440 and the EIL 436.

The second EML 440 includes a fourth compound 442 represented by Formula 6-1, a fifth compound 444 represented by Formula 7-1 and a sixth compound 446 represented by Formula 10-1. The fourth compound 442 may act as a host, the fifth compound 444 may act as an auxiliary dopant (or an auxiliary host), and the sixth compound 446 may act as an emitter. Namely, as mentioned above, the second EML 440 is a fluorescent emitting layer, where the light emission is provided from the sixth compound 446.

For example, the fourth compound 442 may be represented by Formula 6-3, and the fifth compound 444 may be represented by Formula 8-2. The fourth compound 442 may be one of the compounds in Formula 6-4, the fifth compound 444 may be one of the compounds in Formula 8-3, and the sixth compound 446 may be one of the compounds in Formula 10-2.

In the second EML 440, a weight % of the fifth compound 444 may be equal to or smaller than that of the fourth compound 442 and may be greater than that of the sixth compound 446. For example, in the second EML 440, each of the fourth and fifth compounds 442 and 444 may have a weight % of 45 to 50, and the sixth compound 446 may have a weight % of 0.1 to 5.

The CGL 450 is positioned between the first and second emitting parts 410 and 430. Namely, the first and second emitting parts 410 and 430 are connected through the CGL 450. The CGL 450 may be a P-N junction type CGL of an N-type CGL 452 and a P-type CGL 454.

The N-type CGL 452 is positioned between the first ETL 416 and the second HTL 432, and the P-type CGL 454 is positioned between the N-type CGL 452 and the second HTL 432. The N-type CGL 452 provides an electron into the first EML 420 of the first emitting part 410, and the P-type CGL 454 provides a hole into the second EML 440 of the second emitting part 430.

The N-type CGL 452 may include the compound of Formula 3 and Li as a dopant. In the N-type CGL 452, Li may have a weight % of 1 to 10.

The P-type CGL 454 may include the compound in Formula 1 and the compound in Formula 2 as a dopant. In the P-type CGL 454, the compound in Formula 2 may have a weight % of 1 to 10.

In the third pixel region P3, i.e., the blue pixel region, the OLED includes the first and second electrodes 210 and 230 and the light emitting layer 220 between the first and second electrodes 210 and 230, and the light emitting layer 220 includes a first emitting part including a first EML, which is a fluorescent emitting layer, and a second emitting part including a second EML, which is a fluorescent emitting layer. The second emitting part is positioned between the first emitting part and the second electrode 230. The light emitting layer 220 may further include a CGL between the first and second emitting parts. In addition, the OLED may further include a capping layer for enhancing the light extraction.

In the OLED in the third pixel region P3, i.e., the blue pixel region, each of the first and second EMLs may include a host being an anthracene derivative and a fluorescent dopant (emitter) being a pyrene derivative. For example, the host may be one of the compounds in Formula 11, and the fluorescent dopant may be one of the compounds in Formula 12. The host in the first EML and the host in the second EML may be the same or different, and the fluorescent dopant in the first EML and the fluorescent dopant in the second EML may be the same or different.

In the OLED D2-1 in the first pixel region P1, i.e., the red pixel region, and the OLED D2-2 in the second pixel region P2, i.e., the green pixel region, of the organic light emitting display device 100 of the present disclosure, the FWHM of the second EML 340 and 440 at a side of the transparent electrode is smaller than that of the first EML 320 and 420 at a side of the reflection electrode. In addition, the emitting efficiency (quantum efficiency) of the second EML 340 and 440 at a side of the transparent electrode is greater than that of the first EML 320 and 420 at a side of the reflection electrode.

In the OLED D2-1 in the first pixel region P1, i.e., the red pixel region, the FWHM of the second EML 340, which includes the first host 342 being the compound in Formula 15 and the red phosphorescent dopant 344 being one of the compounds in Formula 16, is smaller than that of the first EML 320, which includes the first compound 322 represented by Formula 6-1, the second compound 324 represented by Formula 7-1 and the third compound 326 represented by Formula 9-1. In addition, the emitting efficiency of the second EML 340, which includes the first host 342 being the compound in Formula 15 and the red phosphorescent dopant 344 being one of the compounds in Formula 16, is greater than that of the first EML 320, which includes the first compound 322 represented by Formula 6-1, the second compound 324 represented by Formula 7-1 and the third compound 326 represented by Formula 9-1. Accordingly, by disposing the second EML 340 to be closer to the second electrode 230 being the transparent electrode and the first EML 320 to be closer to the first electrode 210 being the reflection electrode, the micro-cavity effect of the OLED D2-1 in the first pixel region P1 is intensified or amplified. As a result, the emitting efficiency and the lifespan of the OLED D2-1 are improved.

In the OLED D2-2 in the second pixel region P2, i.e., the green pixel region, the FWHM of the second EML 440, which includes the fourth compound 442 represented by Formula 6-1, the fifth compound 444 represented by Formula 7-1 and the sixth compound 446 represented by Formula 10-1, is smaller than that of the first EML 420, which includes the second host 422 being the compound in Formula 17 and the green phosphorescent dopant 424 being one of the compounds in Formula 18. In addition, the emitting efficiency of the second EML 440, which includes the fourth compound 442 represented by Formula 6-1, the fifth compound 444 represented by Formula 7-1 and the sixth compound 446 represented by Formula 10-1, is greater than that of the first EML 420, which includes the second host 422 being the compound in Formula 17 and the green phosphorescent dopant 424 being one of the compounds in Formula 18. Accordingly, by disposing the second EML 440 to be closer to the second electrode 230 being the transparent electrode and the first EML 420 to be closer to the first electrode 210 being the reflection electrode, the micro-cavity effect of the OLED D2-2 in the second pixel region P2 is intensified or amplified. As a result, the emitting efficiency and the lifespan of the OLED D2-2 are improved.

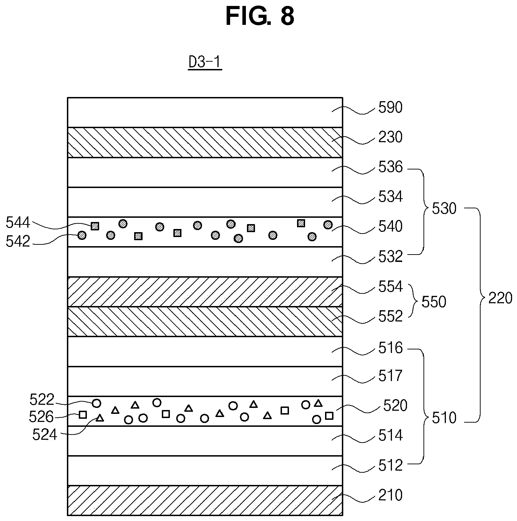

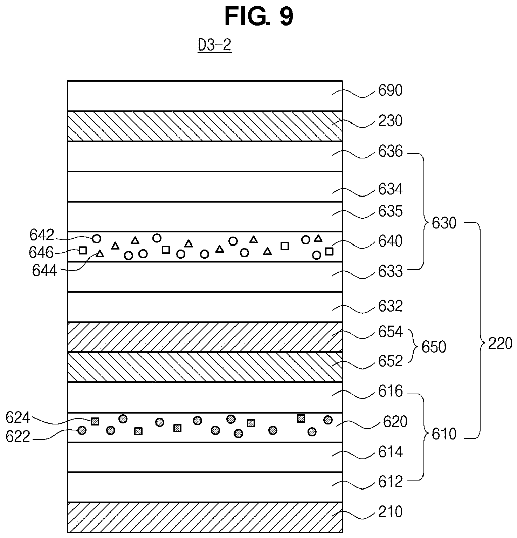

FIG. 8 is a schematic cross-sectional view of an OLED in a red pixel region of an organic light emitting display device according to a fifth embodiment of the present disclosure, and FIG. 9 is a schematic cross-sectional view of an OLED in a green pixel region of an organic light emitting display device according to the fifth embodiment of the present disclosure.

As shown in FIG. 8, the OLED D3-1 includes a first electrode 210 being a reflection electrode, a second electrode 230 being a transparent (or semitransparent) electrode facing the first electrode 210 and a light emitting layer 220 between the first and second electrodes 210 and 230. The light emitting layer 220 includes a first emitting part 510 including a first EML 520, which is a fluorescent emitting layer, and an HBL 517 on the first EML 520 and a second emitting part 530 including a second EML 540, which is a phosphorescent emitting layer. The second emitting part 530 is positioned between the first emitting part 510 and the second electrode 230. The light emitting layer 220 may further include a charge generation layer (CGL) between the first and second emitting parts 510 and 530. In addition, the OLED D3-1 may further include a capping layer 590 for enhancing the light extraction positioned on or over the second electrode 230 as the transparent electrode.

The organic light emitting display device 100 may include a red pixel region, a green pixel region and a blue pixel region, and the OLED D3-1 is positioned in the first pixel region P1 being the red pixel region.

The first electrode 210 may be an anode, and the second electrode 230 may be a cathode.

The first electrode 210 may have a structure of ITO/Ag/ITO, and the second electrode 230 may be formed of MgAg. Alternatively, the first electrode 210 may have a single-layered structure of the ITO layer, and the second electrode 230 may be a reflection electrode. In this instance, the second emitting part 530 including the second EML 540, which is a phosphorescent emitting layer, is positioned to be closer to the first electrode 210, and the first emitting part 510 including the first EML 520, which is a fluorescent emitting layer, is positioned to be closer to the second electrode 230.

Namely, in the OLED D3-1 in the first pixel region P1, i.e., the red pixel region, the second EML 540 being the phosphorescent emitting layer is positioned at a side of the transparent electrode, i.e., a side of a display surface, and the first EML 520 being the fluorescent emitting layer is positioned at a side of the reflection electrode. In other words, the first EML 520 being the fluorescent emitting layer is positioned between the reflection electrode and the second EML 540 being the phosphorescent emitting layer, and the second EML 540 being the phosphorescent emitting layer is positioned between the transparent electrode and the first EML 520 being the fluorescent emitting layer.

The first emitting part 510 may further include at least one of an HIL 512 under the first EML 520, a first HTL 514 between the HIL 512 and the first EML 520 and a first ETL 516 on the HBL 517. In addition, the first emitting part 510 may further include an EBL (not shown) between the first EML 520 and the first HTL 514.

The EBL may be formed of or include the compound in Formula 4, and the HBL 517 may be formed of or include the compound in Formula 5.

The first EML 520 includes a first compound 522 represented by Formula 6-1, a second compound 524 represented by Formula 7-1 and a third compound 526 represented by Formula 9-1. The first compound 522 may act as a host, the second compound 524 may act as an auxiliary dopant (or an auxiliary host), and the third compound 526 may act as an emitter. Namely, as mentioned above, the first EML 520 is a fluorescent emitting layer, where the light emission is provided from the third compound 526.

For example, the first compound 522 may be represented by Formula 6-2, and the second compound 524 may be represented by Formula 8-1. The first compound 522 may be one of the compounds in Formula 6-4, the second compound 524 may be one of the compounds in Formula 8-3, and the third compound 526 may be one of the compounds in Formula 9-2.

In the first EML 520, a weight % of the second compound 524 may be smaller than that of the first compound 522 and may be greater than that of the third compound 526. For example, in the first EML 520, the first compound 522 may have a weight % of 45 to 55, the second compound 524 may have a weight % of 40 to 50, and the third compound 526 may have a weight % of 0.1 to 5.

The second emitting part 530 may further include at least one of a second HTL 532 under the second EML 540, an EIL 536 over the second EML 540 and a second ETL 534 between the second EML 540 and the EIL 536.

Unlike the first emitting part 510, the second emitting part 530 does not include the EBL and the HBL. For example, in the first emitting part 510, since the HBL 517 is presented between the first EML 520 and the first EBL 516, the first EBL 520 contacts the HBL 517 and does not contact the first ETL 516. On the other hand, in the second emitting part 530, the second ETL 534 contacts the second EML 540.

Namely, in the OLED D3-1 in the first pixel region P1, i.e., the red pixel region, the HBL is presented or included in the first emitting part 510 including the first EML 520 being the fluorescent emitting layer and is not presented or included in the second emitting part 530 including the second EML 540 being the phosphorescent emitting layer. The EBL may be presented or included in only the first emitting part 510 or may be not presented or included in both the first and second emitting parts 510 and 530.

In other words, in the first emitting part 510, the first HTL 514 is positioned at one side of the first EML 520, the first ETL 516 is positioned at the other side of the first EML 520, and the HBL, e.g., first HBL, 517 is positioned between the first EML 520 and the first ETL 516. In the second emitting part 530, the second HTL 532 is positioned at one side of the second EML 540, and a second ETL 534 is positioned at the other side of the second EML 540. As a result, the other side of the first EML 520 contacts the HBL 517, and the other side of the second EML 540 contacts the second electron ETL 534. In the first emitting part 510, the EBL, e.g., second EBL, may be positioned between the first EML 520 and the first HTL 514. In this case, the one side of the first EML 520 contacts the EBL, and the one side of the second EML 540 contacts the second HTL 532.

The second EML 540 includes a first host 542 and a red phosphorescent dopant 544. The first host 542 may have a weight % being greater than the red phosphorescent dopant 544. For example, the red phosphorescent dopant 544 may have a weight % of 0.1 to 5 with respect to the first host 542.

The first host 542 is the compound in Formula 15, and the red phosphorescent dopant 544 is one of the compounds in Formula 16.

The CGL 550 is positioned between the first and second emitting parts 510 and 530. Namely, the first and second emitting parts 510 and 530 are connected through the CGL 550. The CGL 550 may be a P-N junction type CGL of an N-type CGL 552 and a P-type CGL 554.

The N-type CGL 552 is positioned between the first ETL 516 and the second HTL 532, and the P-type CGL 554 is positioned between the N-type CGL 552 and the second HTL 532. The N-type CGL 552 provides an electron into the first EML 520 of the first emitting part 510, and the P-type CGL 554 provides a hole into the second EML 540 of the second emitting part 530.

As shown in FIG. 9, the OLED D3-2 includes the first electrode 210 as a reflection electrode, the second electrode 230 as a transparent (or semitransparent) electrode facing the first electrode 210 and the light emitting layer 220 positioned between the first and second electrodes 210 and 230. The light emitting layer 220 includes a first emitting part 610 including a first EML 620, which is a phosphorescent emitting layer, and a second emitting part 630 including a second EML 640, which is a fluorescent emitting layer, an EBL 633 under the second EML 640 and an HBL 635 on the second EML 640. The second emitting part 630 is positioned between the first emitting part 610 and the second electrode 230. The light emitting layer 220 may further include a charge generation layer (CGL) between the first and second emitting parts 610 and 630. In addition, the OLED D3-2 may further include a capping layer 690 for enhancing the light extraction positioned on or over the second electrode 230 as the transparent electrode. The capping layer 590 in the OLED D3-1 and the capping layer 690 in the OLED D3-2 may be formed as one-body to be continuous.

The organic light emitting display device 100 may include a red pixel region, a green pixel region and a blue pixel region, and the OLED D3-2 is positioned in the second pixel region P2 being the green pixel region.

The first electrode 210 may be an anode, and the second electrode 230 may be a cathode.

The first electrode 210 may have a structure of ITO/Ag/ITO, and the second electrode 230 may be formed of MgAg. Alternatively, the first electrode 210 may have a single-layered structure of the ITO layer, and the second electrode 230 may be a reflection electrode. In this instance, the second emitting part 630 including the second EML 640, which is a fluorescent emitting layer, is positioned to be closer to the first electrode 210, and the first emitting part 610 including the first EML 620, which is a phosphorescent emitting layer, is positioned to be closer to the second electrode 230.

Namely, in the OLED D3-2 in the second pixel region P2, i.e., the green pixel region, the second EML 640 being the fluorescent emitting layer is positioned at a side of the transparent electrode, i.e., a side of a display surface, and the first EML 620 being the phosphorescent emitting layer is positioned at a side of the reflection electrode. In other words, the first EML 620 being the phosphorescent emitting layer is positioned between the reflection electrode and the second EML 640 being the fluorescent emitting layer, and the second EML 640 being the fluorescent emitting layer is positioned between the transparent electrode and the first EML 620 being the phosphorescent emitting layer.

The first emitting part 610 may further include at least one of an HIL 612 under the first EML 620, a first HTL 614 between the HIL 612 and the first EML 620 and a first ETL 616 on the first EML 620.

The first EML 620 includes a second host 622 and a green phosphorescent dopant 624. The second host 622 may have a weight % being greater than the green phosphorescent dopant 624. For example, the green phosphorescent dopant 624 may have a weight % of 0.1 to 5 with respect to the second host 622.

The second host 622 is the compound in Formula 17, and the green phosphorescent dopant 624 is one of the compounds in formula 18.

The second emitting part 630 may further include at least one of a second HTL 632 under the EBL 633, an EIL 636 over the HBL 635 and a second ETL 634 between the HBL 635 and the EIL 636.

In the OLED D3-2 in the second pixel region, unlike the second emitting part 640, the first emitting part 610 does not include the EBL and the HBL. For example, in the second emitting part 640, since the EBL 633 and the HBL 635 are respectively presented between the second EML 640 and the second HTL 632 and between the second EML 640 and the second ETL 634, the second EML 640 contacts the EBL 633 and the HBL 635 and does not contact the second HTL 632 and the second ETL 634. On the other hand, in the first emitting part 610, the first HTL 614 and the first ETL 616 contact the first EML 620.

In other words, in the first emitting part 610, e.g., the third emitting part 610, the first HTL 614, e.g., the third HTL, is positioned at one side of the first EML 620, e.g., the third EML, and the first ETL 616, e.g., a third ETL, is positioned at the other side of the first EML 620. In the second emitting part 640, e.g., the fourth emitting part, the second HTL 632, e.g., the fourth HTL, is positioned at one side of the second EML 640, e.g., the fourth EML, the EBL 633, e.g., the first EBL, is positioned between the second EML 640 and the second HTL 632, and second ETL 634, e.g., the fourth ETL, is positioned at the other side of the second EML 640. As a result, the one side of the first EML 620 contacts the first HTL 614, and the one side of the second EML 640 contacts the EBL 633. In the second emitting part 630, the HBL 635, e.g., the second HBL, may be positioned between the second EML 640 and the second ETL 634. In this instance, the other side of the first EML 620 contacts the first ETL 616, and the other side of the second EML 620 contacts the HBL 635.

Namely, in the OLED D3-1 in the second pixel region P2, i.e., the green pixel region, the EBL and the HBL are presented or included in the second emitting part 630 including the second EML 640 being the fluorescent emitting layer and are not presented or included in the first emitting part 610 including the first EML 620 being the phosphorescent emitting layer.

The second EML 640 includes a fourth compound 642 represented by Formula 6-1, a fifth compound 644 represented by Formula 7-1 and a sixth compound 646 represented by Formula 10-1. The fourth compound 642 may act as a host, the fifth compound 644 may act as an auxiliary dopant (or an auxiliary host), and the sixth compound 646 may act as an emitter. Namely, as mentioned above, the second EML 640 is a fluorescent emitting layer, where the light emission is provided from the sixth compound 646.

For example, the fourth compound 642 may be represented by Formula 6-3, and the fifth compound 644 may be represented by Formula 8-2. The fourth compound 642 may be one of the compounds in Formula 6-4, the fifth compound 644 may be one of the compounds in Formula 8-3, and the sixth compound 646 may be one of the compounds in Formula 10-2.

In the second EML 640, a weight % of the fifth compound 644 may be equal to or smaller than that of the fourth compound 642 and may be greater than that of the sixth compound 646. For example, in the second EML 640, each of the fourth and fifth compounds 642 and 644 may have a weight % of 45 to 50, and the sixth compound 646 may have a weight % of 0.1 to 5.

The EBL 633 may be formed of or include the compound in formula 4, and the HBL 635 may be formed of or include the compound in formula 5.

The CGL 650 is positioned between the first and second emitting parts 610 and 630. Namely, the first and second emitting parts 610 and 630 are connected through the CGL 650. The CGL 650 may be a P-N junction type CGL of an N-type CGL 652 and a P-type CGL 654.

The N-type CGL 652 is positioned between the first ETL 616 and the second HTL 632, and the P-type CGL 654 is positioned between the N-type CGL 652 and the second HTL 632. The N-type CGL 652 provides an electron into the first EML 620 of the first emitting part 610, and the P-type CGL 654 provides a hole into the second EML 640 of the second emitting part 630.

In the third pixel region P3, i.e., the blue pixel region, the OLED includes the first and second electrodes 210 and 230 and the light emitting layer 220 between the first and second electrodes 210 and 230, and the light emitting layer 220 includes a first emitting part including a first EML, which is a fluorescent emitting layer, and a second emitting part including a second EML, which is a fluorescent emitting layer. The second emitting part is positioned between the first emitting part and the second electrode 230. The light emitting layer 220 may further include a CGL between the first and second emitting parts. In addition, the OLED may further include a capping layer for enhancing the light extraction.

In the OLED in the third pixel region P3, i.e., the blue pixel region, each of the first and second EMLs may include a host being an anthracene derivative and a fluorescent dopant (emitter) being a pyrene derivative. For example, the host may be one of the compounds in Formula 11, and the fluorescent dopant may be one of the compounds in Formula 12. The host in the first EML and the host in the second EML may be the same or different, and the fluorescent dopant in the first EML and the fluorescent dopant in the second EML may be the same or different.

In the OLED D3-1 in the first pixel region P1, i.e., the red pixel region, and the OLED D3-2 in the second pixel region P2, i.e., the green pixel region, of the organic light emitting display device 100 of the present disclosure, the FWHM of the second EML 540 and 640 at a side of the transparent electrode is smaller than that of the first EML 520 and 620 at a side of the reflection electrode. In addition, the emitting efficiency (quantum efficiency) of the second EML 540 and 640 at a side of the transparent electrode is greater than that of the first EML 520 and 620 at a side of the reflection electrode.

In the OLED D3-1 in the first pixel region P1, i.e., the red pixel region, the FWHM of the second EML 540, which includes the first host 542 being the compound in Formula 15 and the red phosphorescent dopant 544 being one of the compounds in Formula 16, is smaller than that of the first EML 520, which includes the first compound 522 represented by Formula 6-1, the second compound 524 represented by Formula 7-1 and the third compound 526 represented by Formula 9-1. In addition, the emitting efficiency of the second EML 540, which includes the first host 542 being the compound in Formula 15 and the red phosphorescent dopant 544 being one of the compounds in Formula 16, is greater than that of the first EML 520, which includes the first compound 522 represented by Formula 6-1, the second compound 524 represented by Formula 7-1 and the third compound 526 represented by Formula 9-1. Accordingly, by disposing the second EML 540 to be closer to the second electrode 230 being the transparent electrode and the first EML 520 to be closer to the first electrode 210 being the reflection electrode, the micro-cavity effect of the OLED D3-1 in the first pixel region P1 is intensified or amplified. As a result, the emitting efficiency and the lifespan of the OLED D3-1 are improved.

In the OLED D3-2 in the second pixel region P2, i.e., the green pixel region, the FWHM of the second EML 640, which includes the fourth compound 642 represented by Formula 6-1, the fifth compound 644 represented by Formula 7-1 and the sixth compound 646 represented by Formula 10-1, is smaller than that of the first EML 620, which includes the second host 622 being the compound in Formula 17 and the green phosphorescent dopant 624 being one of the compounds in Formula 18. In addition, the emitting efficiency of the second EML 640, which includes the fourth compound 642 represented by Formula 6-1, the fifth compound 644 represented by Formula 7-1 and the sixth compound 646 represented by Formula 10-1, is greater than that of the first EML 620, which includes the second host 622 being the compound in Formula 17 and the green phosphorescent dopant 624 being one of the compounds in Formula 18. Accordingly, by disposing the second EML 640 to be closer to the second electrode 230 being the transparent electrode and the first EML 620 to be closer to the first electrode 210 being the reflection electrode, the micro-cavity effect of the OLED D3-2 in the second pixel region P2 is intensified or amplified. As a result, the emitting efficiency and the lifespan of the OLED D3-2 are improved.

### [OLED2]

An anode, an HIL (the compound in Formula 12-1 and the compound in Formula 2 (8wt%), 70nm), a first HTL (the compound in Formula 12-1, 30nm), a first EML (45nm), a first ETL (the compound in Formula 12-2, 15nm), an N-type CGL (the compound in Formula 12-2 and Li (2wt%), 10nm), a P-type CGL (the compound in Formula 12-1 and the compound in Formula 2 (8wt%), 8nm), a second HTL (the compound in Formula 12-1, 30nm), a second EML (45nm), a second ETL (the compound in Formula 12-2, 30nm), an EIL (LiF, 5nm), a cathode (Ag:Mg, 15nm) and a capping layer (the compound in Formula 12-3, 100nm) are sequentially deposited to form an OLED in the red pixel region.

### 1. Comparative Examples

### (1) Comparative Example 7 (Ref7)

The compound 1-5 in Formula 6-4 (50wt%), the compound 2-1 in Formula 8-3 (49.5wt%) and the compound 3-1 in Formula 9-2 (0.5wt%) are used to form the first and second EMLs.

### (2) Comparative Example 8 (Ref8)

The compound in Formula 15 (98 wt%) and the compound 16-1 in Formula 16 (2 wt%) are used to form the first EML, and the compound 1-5 in Formula 6-4 (50wt%), the compound 2-1 in Formula 8-3 (49.5wt%) and the compound 3-1 in Formula 9-2 (0.5wt%) are used to form the second EML.

### 2. Examples

### (1) Example 5 (Ex5)

The compound 1-5 in Formula 6-4 (50wt%), the compound 2-1 in Formula 8-3 (49.5wt%) and the compound 3-1 in Formula 9-2 (0.5wt%) are used to form the first EML, and the compound in Formula 15 (98 wt%) and the compound 16-1 in Formula 16 (2 wt%) are used to form the second EML.

### (2) Example 6 (Ex6)

The compound 1-5 in Formula 6-4 (50wt%), the compound 2-1 in Formula 8-3 (49.5wt%) and the compound 3-1 in Formula 9-2 (0.5wt%) are used to form the first EML, and the compound in Formula 15 (98 wt%) and the compound 16-1 in Formula 16 (2 wt%) are used to form the second EML. In addition, the compound in Formula 5 is used to form an HBL (10nm) between the first EML and the first ETL.

### (3) Example 7 (Ex7)

The compound 1-5 in Formula 6-4 (50wt%), the compound 2-1 in Formula 8-3 (49.5wt%) and the compound 3-1 in Formula 9-2 (0.5wt%) are used to form the first EML, and the compound in Formula 15 (98 wt%) and the compound 16-1 in Formula 16 (2 wt%) are used to form the second EML. In addition, the compound in Formula 4 is used to form an EBL (10nm) between the first EML and the first HTL, and the compound in Formula 5 is used to form an HBL (10nm) between the first EML and the first ETL.

The emitting properties, i.e., the driving voltage (V), the emitting efficiency (cd/A), the color coordinate index (CIE) and the lifespan (T95), of the OLED in Comparative Examples 7 and 8 and Examples 5 to 7 are measured and listed in Table 2.

**Table 2**

| | Voltage (V) | cd/A | CIE | T95 (hr) |
|---|---|---|---|---|
| Ref7 | 10.51 | 50.5 | (0.683, 0.315) | 731 |
| Ref8 | 7.67 | 74.4 | (0.690, 0.308) | 919 |
| Ex5 | 7.96 | 74.6 | (0.685, 0.314) | 1450 |
| Ex6 | 7.53 | 98.3 | (0.679, 0.319) | 1780 |
| Ex7 | 7.42 | 85.7 | (0.673, 0.324) | 1730 |

As shown in Table 2, in comparison to the OLED of Ref7, which includes two fluorescent emitting layers, the OLED of Ref8, Ex5, Ex6 and Ex7, which includes a fluorescent emitting layer and a phosphorescent emitting layer, has advantages in the driving voltage, the emitting efficiency and the lifespan.

On the other hand, in comparison to the OLED of Ref8, in which the fluorescent emitting layer is disposed at a side of the cathode, the OLED of Ex5, Ex6 and Ex7, in which the phosphorescent emitting layer is disposed at a side of the cathode being the transparent electrode has advantages in the driving voltage, the emitting efficiency and the lifespan.

In addition, the OLED of Ex6 and Ex7 including the HBL and/or the EBL being adjacent to the fluorescent emitting layer has big advantages in the emitting efficiency and the lifespan.

Moreover, in the OLED of Ex6 including the HBL being adjacent to the fluorescent emitting layer without the EBL, the emitting efficiency and the lifespan are further improved.

### [OLED3]

An anode, an HIL (the compound in Formula 12-1 and the compound in Formula 2 (8wt%), 70nm), a first HTL (the compound in Formula 12-1, 30nm), a first EML (45nm), a first ETL (the compound in Formula 12-2, 15nm), an N-type CGL (the compound in Formula 12-2 and Li (2wt%), 10nm), a P-type CGL (the compound in Formula 12-1 and the compound in Formula 2 (8wt%), 8nm), a second HTL (the compound in Formula 12-1, 30nm), a second EML (45nm), a second ETL (the compound in Formula 12-2, 30nm), an EIL (LiF, 5nm), a cathode (Ag:Mg, 15nm) and a capping layer (the compound in Formula 12-3, 100nm) are sequentially deposited to form an OLED in the green pixel region.

### 1. Comparative Examples

### (1) Comparative Example 9 (Ref9)

The compound 1-1 in Formula 6-4 (49.9wt%), the compound 2-6 in Formula 8-3 (49.9wt%) and the compound 4-1 in Formula 10-2 (0.2wt%) are used to form the first and second EMLs.

### (2) Comparative Example 10 (Ref10)

The compound 1-1 in Formula 6-4 (49.9wt%), the compound 2-6 in Formula 8-3 (49.9wt%) and the compound 4-1 in Formula 10-2 (0.2wt%) are used to form the first EML, and the compound in Formula 17 (98wt%) and the compound 18-4 in Formula 18 (2wt%) are used to form the second EML.

### 2. Examples

### (1) Example 8 (Ex8)

The compound in Formula 17 (98wt%) and the compound 18-4 in Formula 18 (2wt%) are used to form the first EML, and the compound 1-1 in Formula 6-4 (49.9wt%), the compound 2-6 in Formula 8-3 (49.9wt%) and the compound 4-1 in Formula 10-2 (0.2wt%) are used to form the second EML.

### (2) Example 9 (Ex9)

The compound in Formula 17 (98wt%) and the compound 18-4 in Formula 18 (2wt%) are used to form the first EML, and the compound 1-1 in Formula 6-4 (49.9wt%), the compound 2-6 in Formula 8-3 (49.9wt%) and the compound 4-1 in Formula 10-2 (0.2wt%) are used to form the second EML. In addition, the compound in Formula 4 is used to form an EBL (10nm) between the second EML and the second HTL.

### (3) Example 10 (Ex10)

The compound in Formula 17 (98wt%) and the compound 18-4 in Formula 18 (2wt%) are used to form the first EML, and the compound 1-1 in Formula 6-4 (49.9wt%), the compound 2-6 in Formula 8-3 (49.9wt%) and the compound 4-1 in Formula 10-2 (0.2wt%) are used to form the second EML. In addition, the compound in Formula 4 is used to form an EBL (10nm) between the second EML and the second HTL, and the compound in Formula 5 is used to form an HBL (10nm) between the first EML and the first ETL.

The emitting properties, i.e., the driving voltage (V), the emitting efficiency (cd/A), the color coordinate index (CIE) and the lifespan (T95), of the OLED in Comparative Examples 9 and 10 and Examples 8 to 10 are measured and listed in Table 3.

**Table 3**

| | Voltage (V) | cd/A | CIE | T95 (hr) |
|---|---|---|---|---|
| Ref9 | 8.4 | 189.1 | (0.229, 0.727) | 300 |
| Ref10 | 8.2 | 191.8 | (0.266, 0.705) | 427 |
| Ex8 | 8.3 | 204.9 | (0.269, 0.705) | 443 |
| Ex9 | 8.1 | 208.0 | (0.258, 0.712) | 481 |
| Ex10 | 8.01 | 222.2 | (0.274, 0.697) | 450 |

As shown in Table 3, in comparison to the OLED of Ref9, which includes two fluorescent emitting layers, the OLED of Ref10, Ex8, Ex9 and Ex10, which includes a fluorescent emitting layer and a phosphorescent emitting layer, has advantages in the driving voltage, the emitting efficiency and the lifespan.

On the other hand, in comparison to the OLED of Ref10, in which the phosphorescent emitting layer is disposed at a side of the cathode, the OLED of Ex8, Ex9 and Ex10, in which the fluorescent emitting layer is disposed at a side of the cathode being the transparent electrode has advantages in the driving voltage, the emitting efficiency and the lifespan.

In addition, the OLED of Ex9 and Ex10 including the HBL and/or the EBL being adjacent to the fluorescent emitting layer has big advantages in the emitting efficiency and the lifespan. Moreover, in the OLED of Ex9 including the EBL being adjacent to the fluorescent emitting layer without the HBL, the lifespan is further improved.

It will be apparent to those skilled in the art that various modifications and variations can be made in the present disclosure without departing from the scope of the present disclosure. Thus, it is intended that the present invention cover the modifications and variations of this disclosure provided they come within the scope of the appended claims.

Also disclosed are the following numbered clauses:
1. An organic light emitting display device (100), comprising: a substrate (110) including first to third pixel regions (P1, P2, P3); and an organic light emitting diode including a transparent electrode (230), a reflective electrode (210) and a light emitting layer (220) between the transparent electrode (230) and the reflective electrode (210), wherein the light emitting layer (220) in the organic light emitting diode (D) in the first pixel region (P1) includes a first emitting part (310) including a first emitting material layer (320) and second emitting part (330) including a second emitting material layer (340), and the second emitting part (330) is positioned between the first emitting material layer (320) and the transparent electrode (230), wherein the light emitting layer (220) in the organic light emitting diode (D) in the second pixel region (P2) includes a third emitting part (410) including a third emitting material layer (420) and fourth emitting part (430) including a fourth emitting material layer (440), and the fourth emitting part (430) is positioned between the third emitting material layer (420) and the transparent electrode (230), and wherein each of the first and fourth emitting material layers (320, 440) is a fluorescent emitting layer, and each of the second and third emitting material layers (340, 420) is a phosphorescent emitting layer.
2. The organic light emitting display device (100) according to clause 1, wherein the first emitting material layer (320) includes first to third compounds (322, 324, 326), wherein the first compound (322) is represented by Formula 6-1: 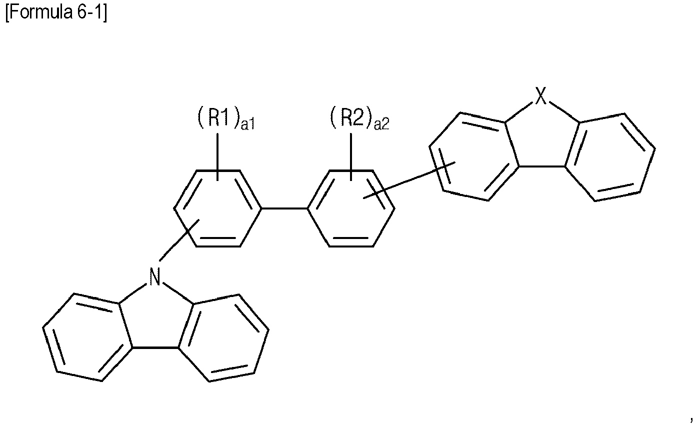
   wherein in Formula 6-1, each of a1 and a2 is independently an integer of 0 to 4, wherein each of R1 and R2 is independently selected from the group consisting of deuterium and a substituted or unsubstituted C1 to C10 alkyl group, or adjacent R1 and R2 is connected to each other to form a ring including O or S, wherein X is selected from the group consisting of O, S and NR3, and R3 is selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group, wherein the second compound (324) is represented by Formula 7-1: 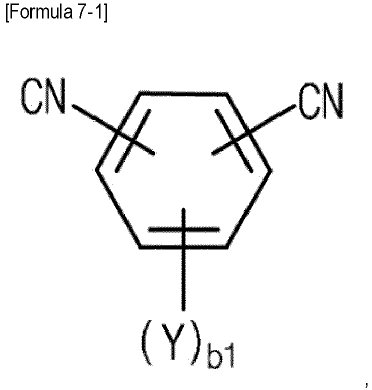
   wherein in Formula 7-1, b1 is an integer of 1 to 4, and Y is represented by Formula 7-2: 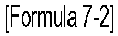 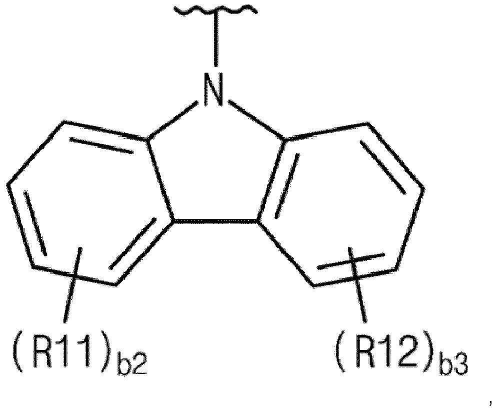
   wherein in Formula 7-2, each of R11 and R12 is independently selected from the group consisting of deuterium, a substituted or unsubstituted C1 to C10 alkyl group, a substituted or unsubstituted C6 to C30 aryl group and a substituted or unsubstituted C5 to C30 heteroaryl group, and each of b2 and b3 is independently an integer of 0 to 4, wherein the third compound (326) is represented by Formula 9-1: 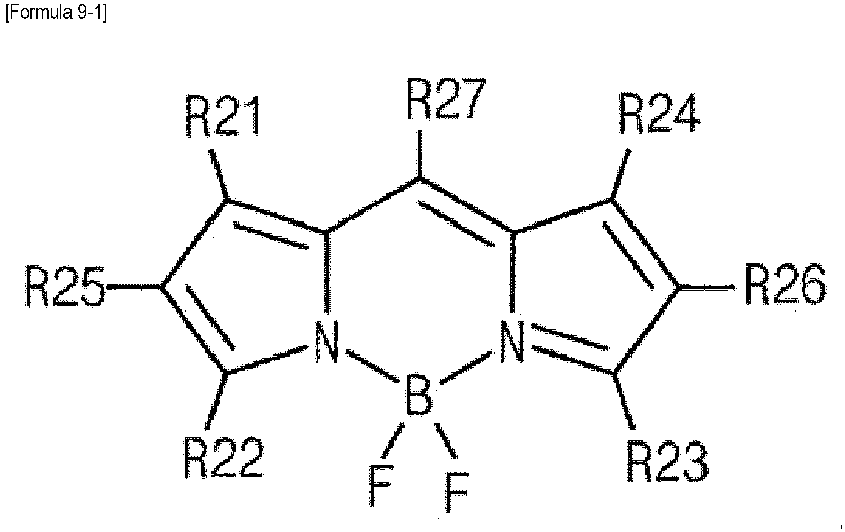 and
   wherein in Formula 9-1, each of R21, R22, R23 and R24 is independently a substituted or unsubstituted C6 to C30 aryl group, and each of R25, R26 and R27 is independently selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group.
3. The organic light emitting display device (100) according to clause 2, wherein Formula 6-1 is represented by Formula 6-2: 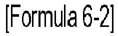 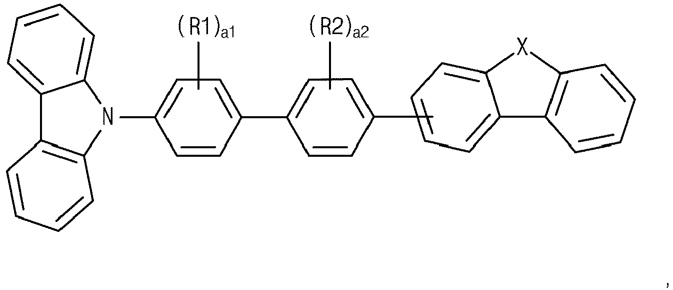 wherein the definitions of R1, R2, X, a1 and a2 are same as those in Formula 6-1.
4. The organic light emitting display device (100) according to clause 2, wherein the first compound (322) is one of compounds in Formula 6-4: 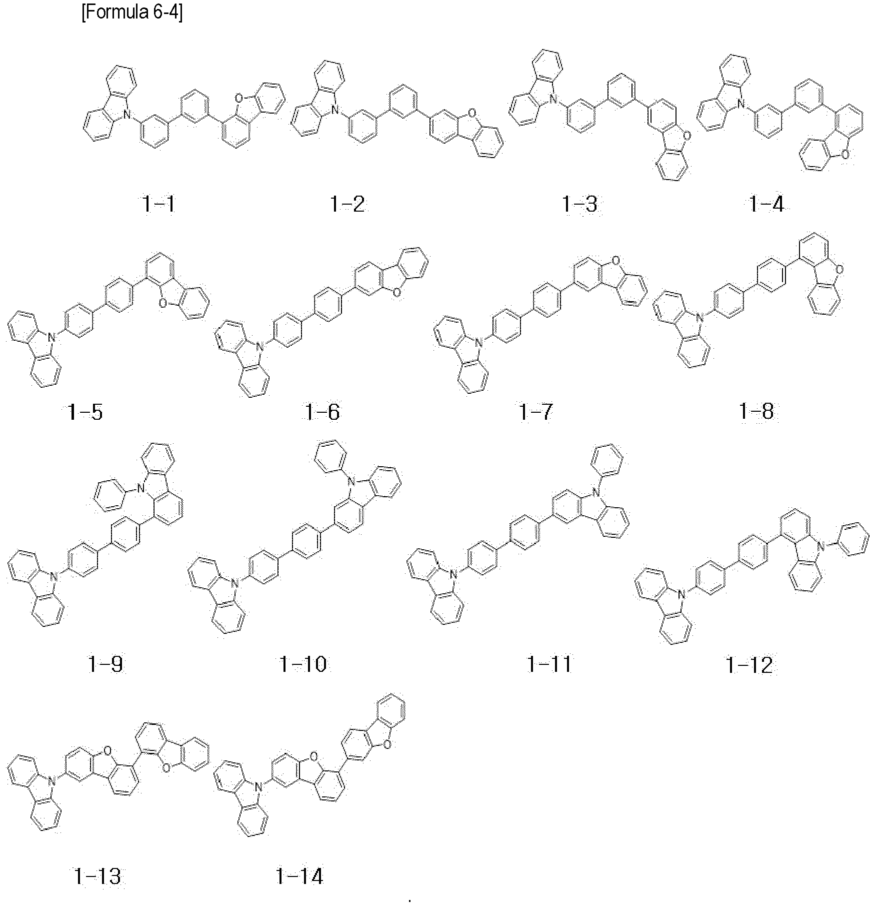
5. The organic light emitting display device (100) according to clause 2, wherein Formula 7-1 is represented by Formula 8-1: 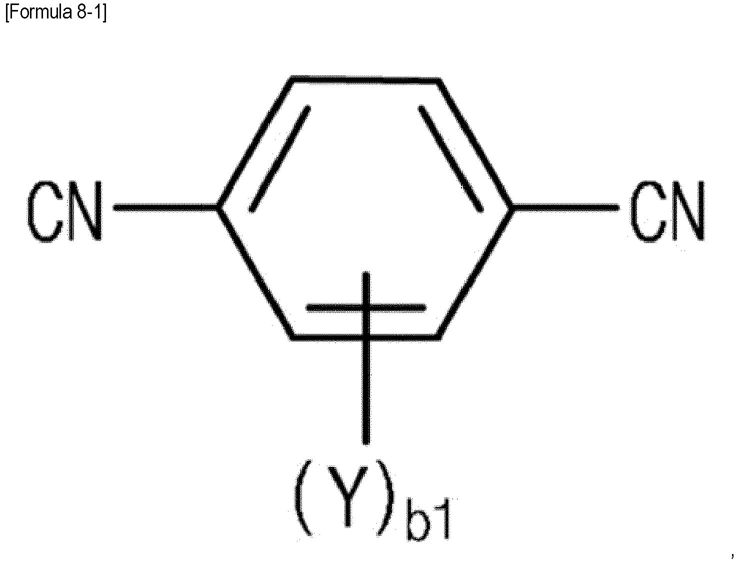 wherein Y is represented by Formula 7-2, and the definition of b1 is the same as that in Formula 7-1.
6. The organic light emitting display device (100) according to clause 2, wherein the second compound (324) is one of compounds in Formula 8-3: 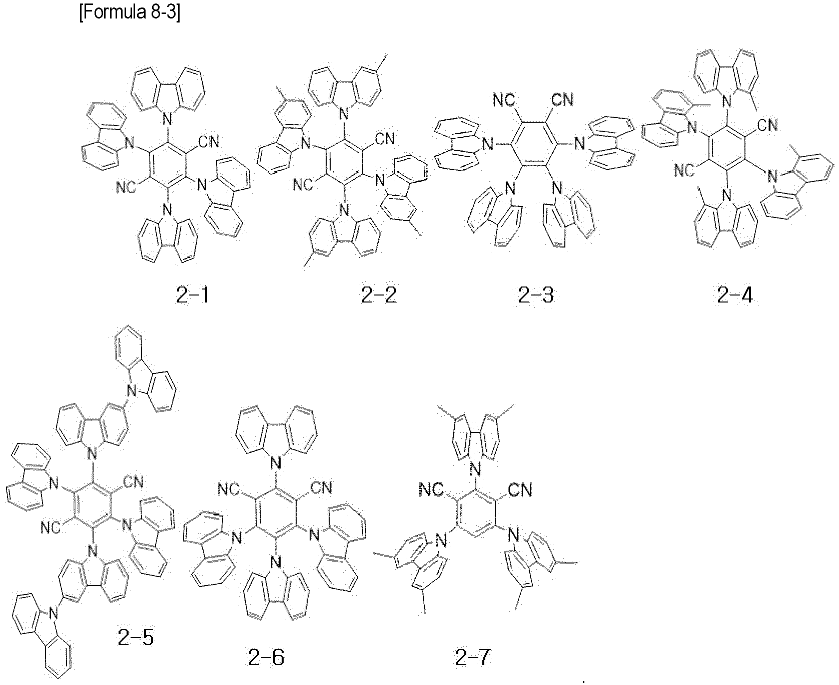
7. The organic light emitting display device (100) according to clause 2, wherein the third compound (326) is one of compounds in Formula 9-2: 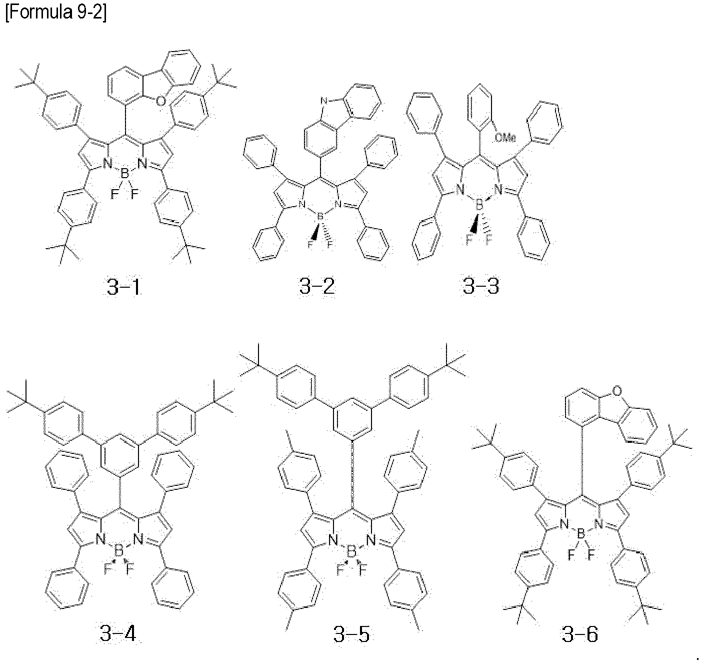
8. The organic light emitting display device (100) according to clause 2, wherein the second emitting material layer (340) includes a first host (342) and a first phosphorescent dopant (344), and wherein the first host (342) is a compound in Formula 15, and the first phosphorescent dopant (344) is one of compounds in Formula 16: 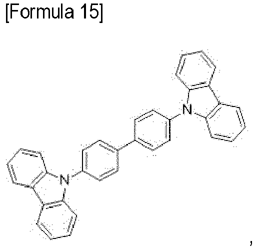 and 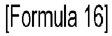 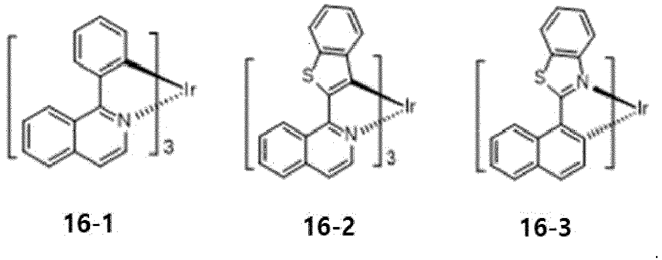
9. The organic light emitting display device (100) according to any preceding clause, wherein the fourth emitting material layer (440) includes fourth to sixth compounds (442, 444, 446), wherein the fourth compound (442) is represented by Formula 6-1: 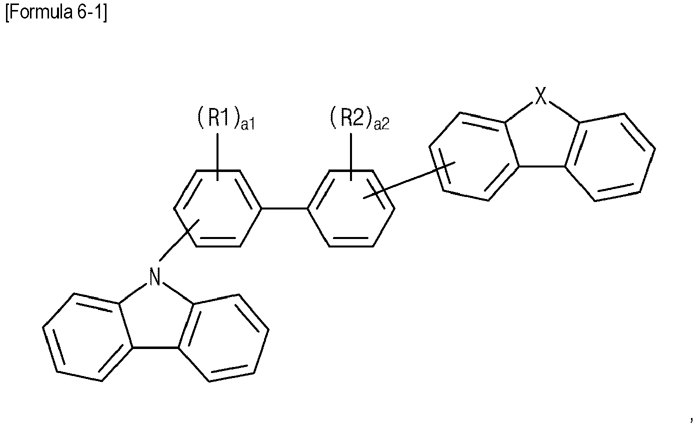
   wherein in Formula 6-1, each of a1 and a2 is independently an integer of 0 to 4, wherein each of R1 and R2 is independently selected from the group consisting of deuterium and a substituted or unsubstituted C1 to C10 alkyl group, or adjacent R1 and R2 is connected to each other to form a ring including O or S, wherein X is selected from the group consisting of O, S and NR3, and R3 is selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group,
   wherein the fifth compound (444) is represented by Formula 7-1: 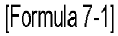 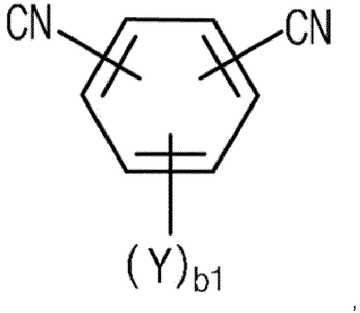
      wherein in Formula 7-1, b1 is an integer of 1 to 4, and Y is represented by Formula 7-2: 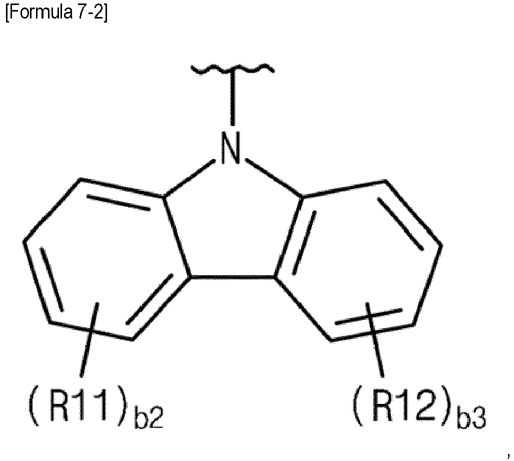
      wherein in Formula 7-2, each of R11 and R12 is independently selected from the group consisting of deuterium, a substituted or unsubstituted C1 to C10 alkyl group, a substituted or unsubstituted C6 to C30 aryl group and a substituted or unsubstituted C5 to C30 heteroaryl group, and each of b2 and b3 is independently an integer of 0 to 4,
      wherein the sixth compound (446) is represented by Formula 10-1: 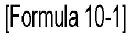 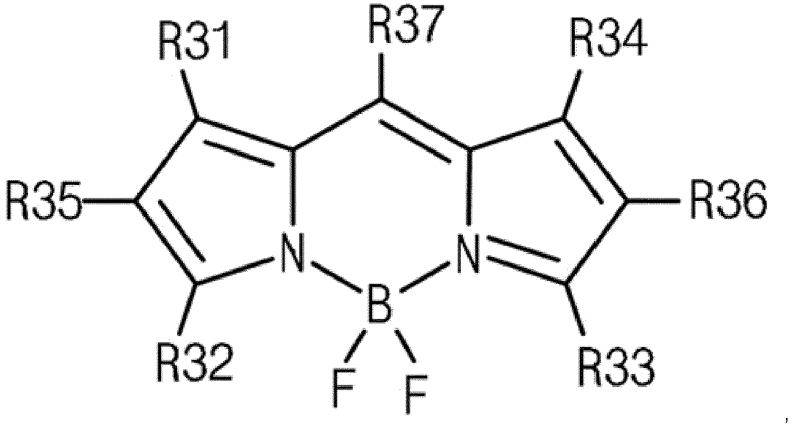
      wherein in Formula 10-1, each of R31, R32, R33 and R34 is independently selected from the group consisting of hydrogen and a substituted or unsubstituted C1 to C10 alkyl group, and at least one of R31, R32, R33 and R34 is a substituted or unsubstituted C1 to C10 alkyl group, and
      wherein each of R35, R36 and R37 is independently selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group.
10. The organic light emitting display device (100) according to clause 9, wherein Formula 6-1 is represented by Formula 6-3: 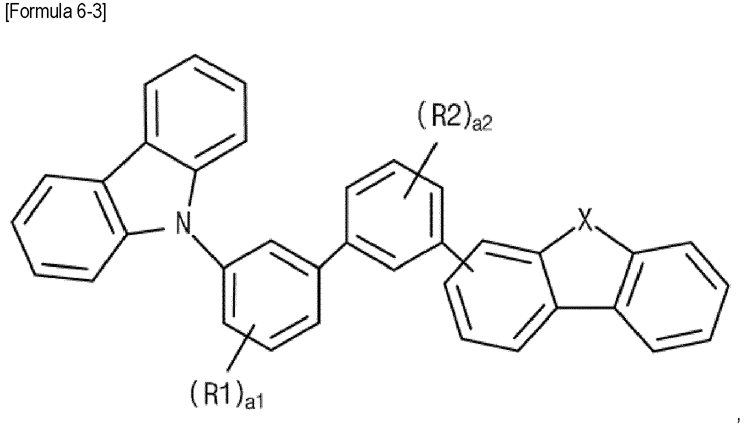 wherein the definitions of R1, R2, X, a1 and a2 are same as those in Formula 6-1.
11. The organic light emitting display device (100) according to clause 9, wherein the fourth compound (442) is one of compounds in Formula 6-4: 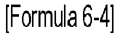 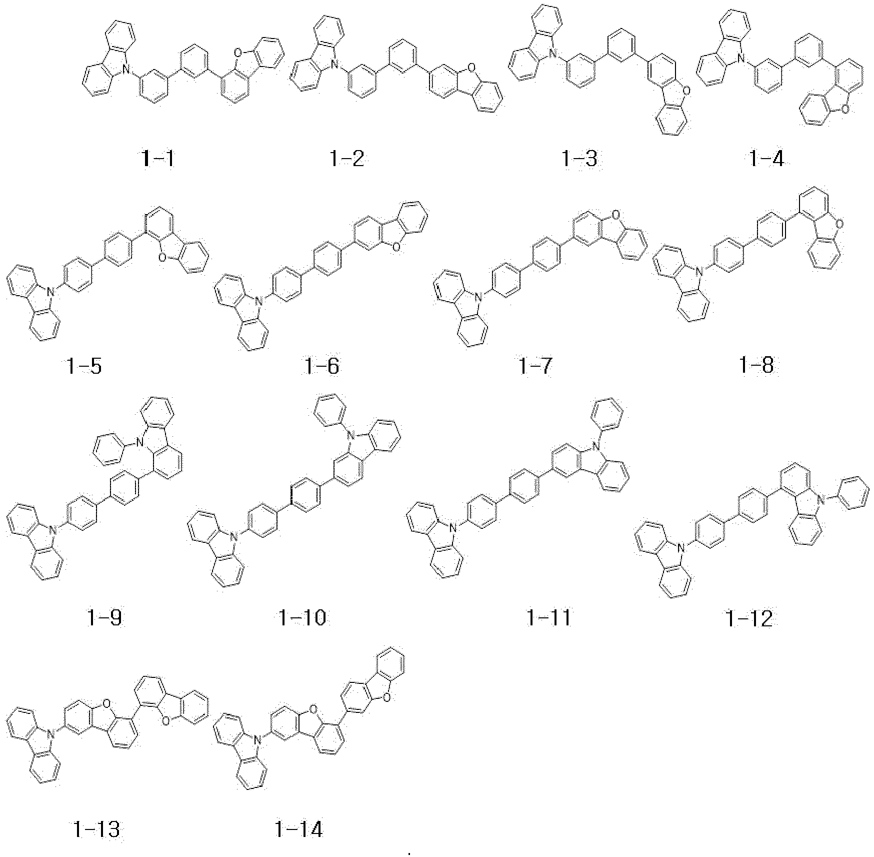
12. The organic light emitting display device (100) according to clause 9, wherein Formula 7-1 is represented by Formula 8-2: 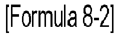 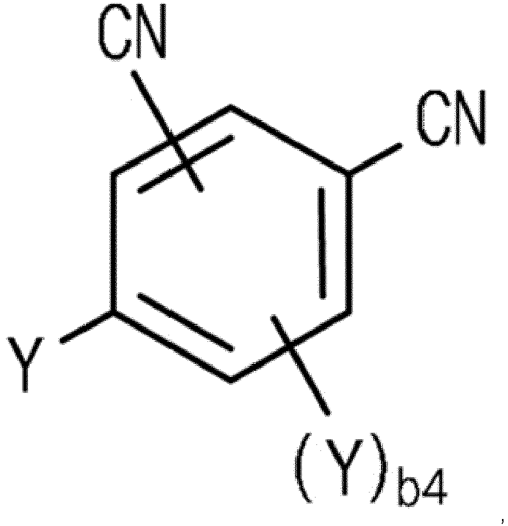 wherein Y is represented by Formula 7-2, and b4 is an integer of 0 to 3.
13. The organic light emitting display device (100) according to clause 9, wherein the fifth compound (444) is one of compounds in Formula 8-3: 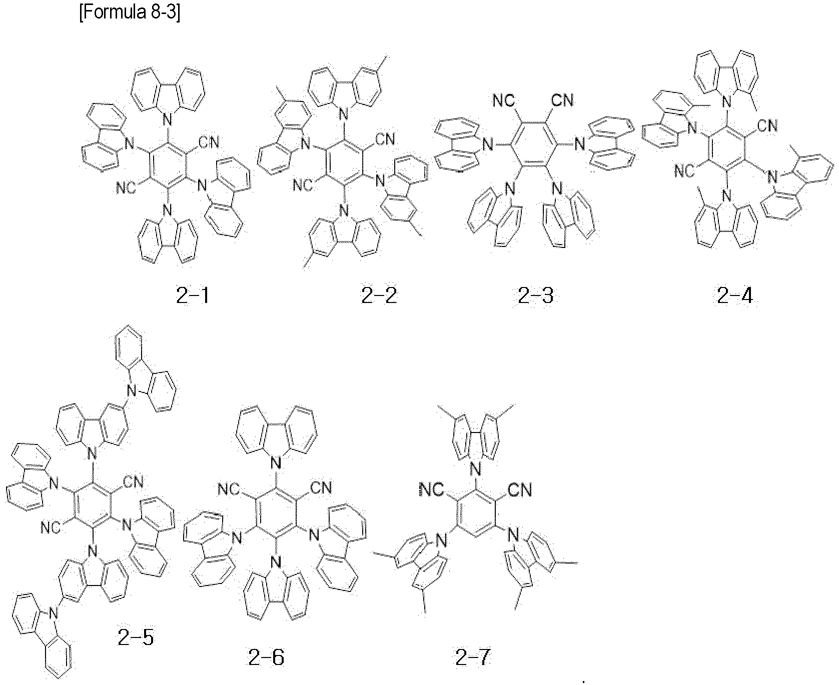
14. The organic light emitting display device (100) according to clause 9, wherein the sixth compound (446) is one of compounds in Formula 10-2: 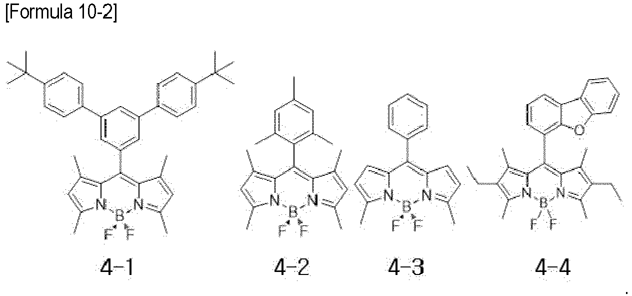
15. The organic light emitting display device (100) according to clause 9, wherein the third emitting material layer (420) includes a second host (422) and a second phosphorescent dopant (424), and wherein the second host (422) is a compound in Formula 17, and the second phosphorescent dopant (424) is one of compounds in Formula 18: 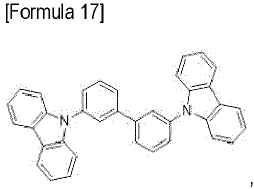 and 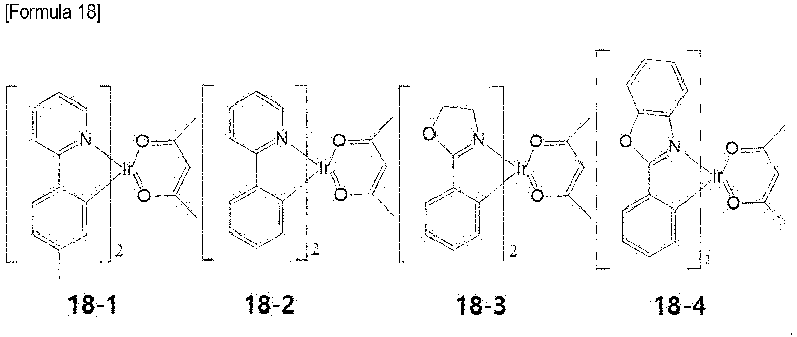
16. The organic light emitting display device (100) according to any preceding clause, wherein the first emitting part (510) further includes a first hole transporting layer (514) at one side of the first emitting material layer (520), a first electron transporting layer (516) at the other side of the first emitting material layer (520) and a first hole blocking layer (517) between the first emitting material layer (520) and the first electron transporting layer (516), wherein the second emitting part (530) further includes a second hole transporting layer (532) at one side of the second emitting material layer (540) and a second electron transporting layer (534) at the other side of the second emitting material layer (540), wherein the third emitting part (610) further includes a third hole transporting layer (614) at one side of the third emitting material layer (620) and a third electron transporting layer (616) at the other side of the third emitting material layer (620), and wherein the fourth emitting part (630) further includes a fourth hole transporting layer (632) at one side of the fourth emitting material layer (640), a first electron blocking layer (633) between the fourth emitting material layer (640) and the fourth hole transporting layer (632) and a fourth electron transporting layer (634) at the other side of the fourth emitting material layer (640).
17. The organic light emitting display device (100) according to clause 16, wherein the other side of the first emitting material layer (520) contacts the first hole blocking layer (517), and the other side of the second emitting material layer (540) contacts the second electron transporting layer (534), and wherein the one side of the third emitting material layer (620) contacts the third hole transporting layer (614), and the one side of the fourth emitting material layer (640) contacts the first electron blocking layer (633).
18. The organic light emitting display device (100) according to clause 16 or 17, wherein the first emitting part (510) further includes a second electron blocking layer between the first emitting material layer (520) and the first hole transporting layer (514), and the fourth emitting part (630) further includes a second hole blocking layer (635) between the fourth emitting material layer (440) and the fourth electron transporting layer (634).
19. The organic light emitting display device (100) according to clause 18, wherein the one side of the first emitting material layer (520) contacts the second electron blocking layer, and the one side of the second emitting material layer (540) contacts the second hole transporting layer (532), and wherein the other side of the third emitting material layer (620) contacts the third electron transporting layer (616), and the other side of the fourth emitting material layer (640) contacts the second hole blocking layer (635).
20. The organic light emitting display device (100) according to any preceding clause, wherein a full width at a half maximum of the second emitting material layer (540) is smaller than that of the first emitting material layer (520), and an emitting efficiency of the second emitting material layer (540) is greater than that of the first emitting material layer (520), and wherein a full width at a half maximum of the fourth emitting material layer (640) is smaller than that of the third emitting material layer (620), and an emitting efficiency of the fourth emitting material layer (640) is greater than that of the third emitting material layer (620).

## Claims

1. An organic light emitting display device (100), comprising:
a substrate (110) including first to third pixel regions (P1, P2, P3); and
an organic light emitting diode (D) in each of the pixel regions (P1, P2, P3), each organic light emitting diode (D) including a transparent electrode (230), a reflective electrode (210) and a light emitting layer (220) between the transparent electrode (230) and the reflective electrode (210),
wherein the light emitting layer (220) in the organic light emitting diode (D) in the first pixel region (P1) includes a first emitting part (310) including a first emitting material layer (320) and second emitting part (330) including a second emitting material layer (340), and the second emitting part (330) is positioned between the first emitting material layer (320) and the transparent electrode (230),
wherein the first emitting material layer (320) is a fluorescent emitting layer, and the second emitting material layer (340) is a phosphorescent emitting layer, and
wherein a full width at a half maximum of the second emitting material layer (340) is smaller than that of the first emitting material layer (320), and an emitting efficiency of the second emitting material layer (340) is greater than that of the first emitting material layer (320).

2. The organic light emitting display device (100) according to claim 1, wherein the light emitting layer (220) in the organic light emitting diode (D) in the second pixel region (P2) includes a third emitting part (410) including a third emitting material layer (420) and a fourth emitting part (430) including a fourth emitting material layer (440), and the fourth emitting part (430) is positioned between the third emitting material layer (420) and the transparent electrode (230), and
wherein the fourth emitting material layer (440) is a fluorescent emitting layer, and the third emitting material layer (420) is a phosphorescent emitting layer.

3. The organic light emitting display device (100) according to claim 2, wherein a full width at a half maximum of the fourth emitting material layer (440) is smaller than that of the third emitting material layer (420), and an emitting efficiency of the fourth emitting material layer (440) is greater than that of the third emitting material layer (420).

4. The organic light emitting display device (100) according to any preceding claim, wherein the first emitting part (510) further includes a first hole transporting layer (514) at one side of the first emitting material layer (520), a first electron transporting layer (516) at the other side of the first emitting material layer (520) and a first hole blocking layer (517) between the first emitting material layer (520) and the first electron transporting layer (516).

5. The organic light emitting display device (100) according to claim 3 or 4 when dependent on claim 2, wherein the fourth emitting part (630) further includes a fourth hole transporting layer (632) at one side of the fourth emitting material layer (640), a first electron blocking layer (633) between the fourth emitting material layer (640) and the fourth hole transporting layer (632) and a fourth electron transporting layer (634) at the other side of the fourth emitting material layer (640).

6. The organic light emitting display device (100) according to any preceding claim, wherein the first emitting material layer (320) includes first to third compounds (322, 324, 326),
wherein the first compound (322) is represented by Formula 6-1: 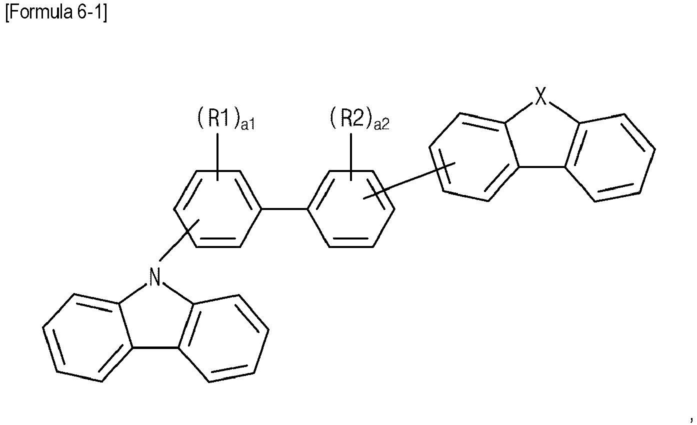
wherein in Formula 6-1, each of a1 and a2 is independently an integer of 0 to 4,
wherein each of R1 and R2 is independently selected from the group consisting of deuterium and a substituted or unsubstituted C1 to C10 alkyl group, or adjacent R1 and R2 is connected to each other to form a ring including O or S,
wherein X is selected from the group consisting of O, S and NR3, and R3 is selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group,
wherein the second compound (324) is represented by Formula 7-1: 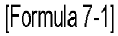 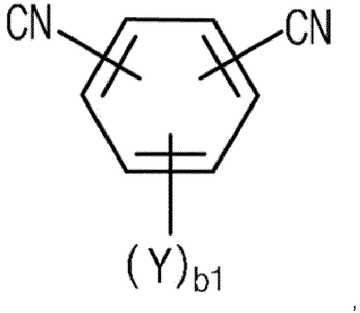
wherein in Formula 7-1, b1 is an integer of 1 to 4, and Y is represented by Formula 7-2: 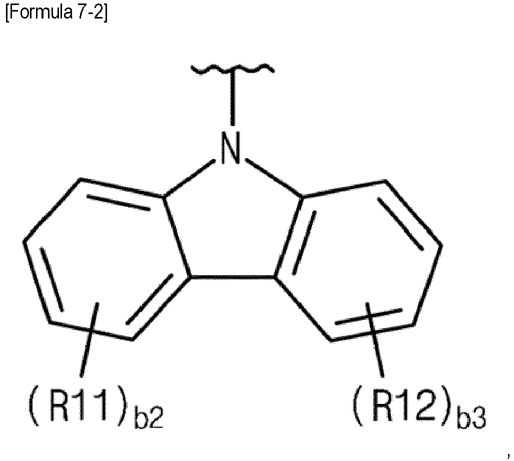
wherein in Formula 7-2, each of R11 and R12 is independently selected from the group consisting of deuterium, a substituted or unsubstituted C1 to C10 alkyl group, a substituted or unsubstituted C6 to C30 aryl group and a substituted or unsubstituted C5 to C30 heteroaryl group, and each of b2 and b3 is independently an integer of 0 to 4,
wherein the third compound (326) is represented by Formula 9-1: 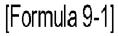 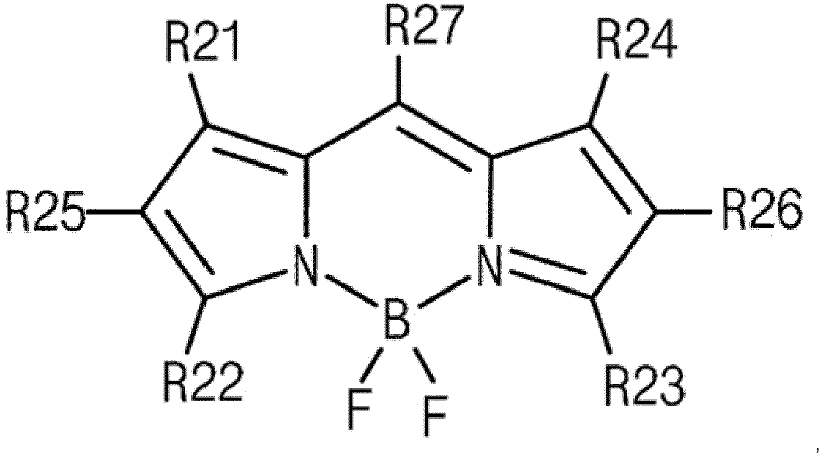 and
wherein in Formula 9-1, each of R21, R22, R23 and R24 is independently a substituted or unsubstituted C6 to C30 aryl group, and each of R25, R26 and R27 is independently selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group2, optionally wherein Formula 6-1 is represented by Formula 6-2: 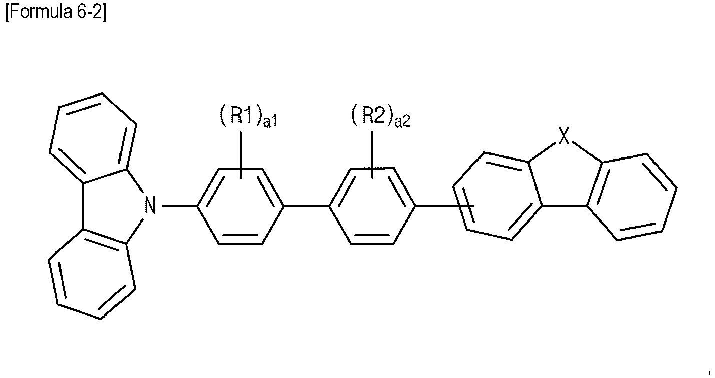
wherein the definitions of R1, R2, X, a1 and a2 are same as those in Formula 6-1 , and further optionally wherein the first compound (322) is one of compounds in Formula 6-4:

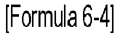

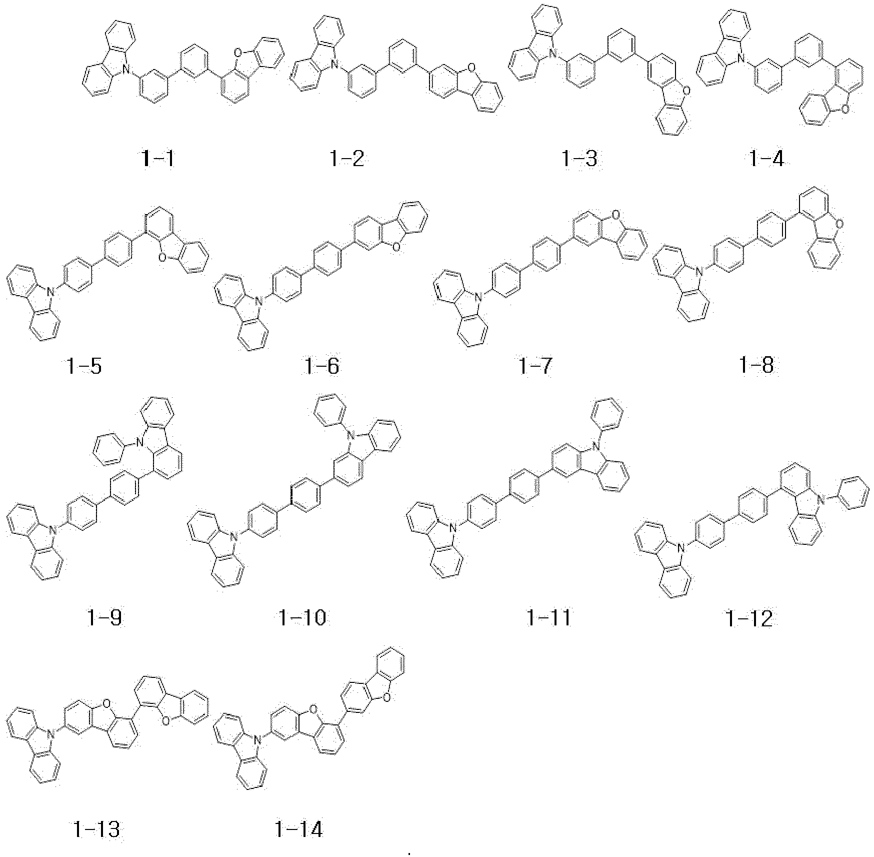

7. The organic light emitting display device (100) according to claim 6, wherein Formula 7-1 is represented by Formula 8-1: 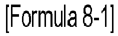 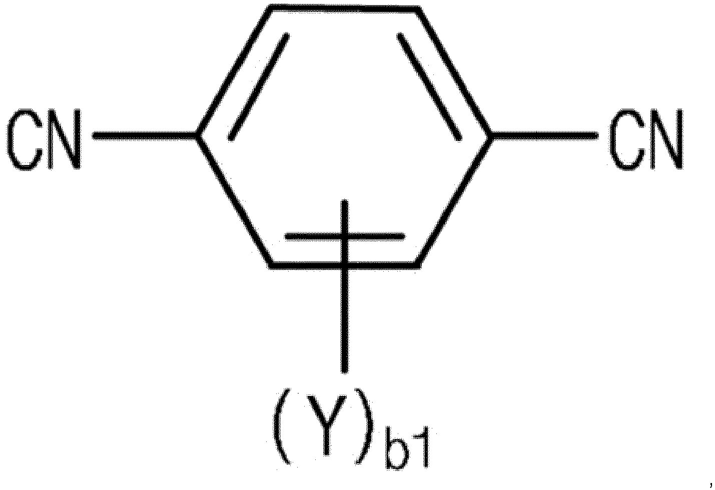 wherein Y is represented by Formula 7-2, and the definition of b1 is the same as that in Formula 7-1.

8. The organic light emitting display device (100) according to claim 6 or 7, wherein the second compound (324) is one of compounds in Formula 8-3: 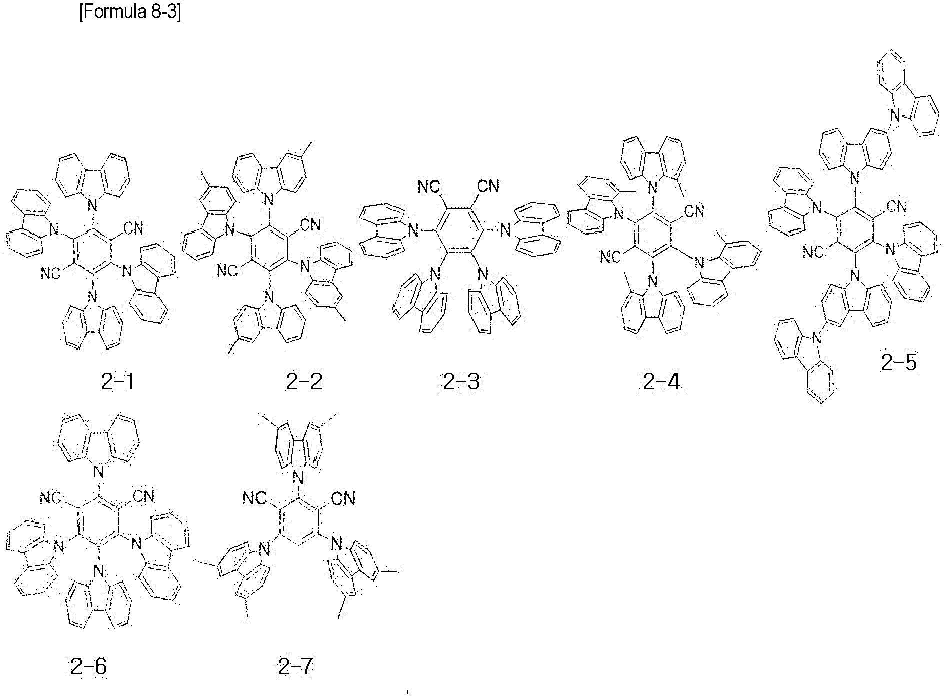 and/or
wherein the third compound (326) is one of compounds in Formula 9-2:

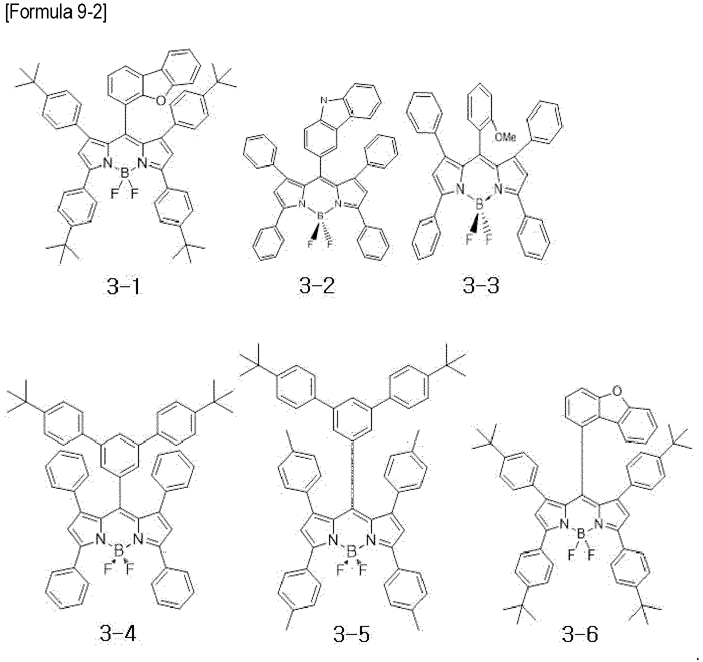

9. The organic light emitting display device (100) according to any of claims 6 to 8, wherein the second emitting material layer (340) includes a first host (342) and a first phosphorescent dopant (344), and
wherein the first host (342) is a compound in Formula 15, and the first phosphorescent dopant (344) is one of compounds in Formula 16: 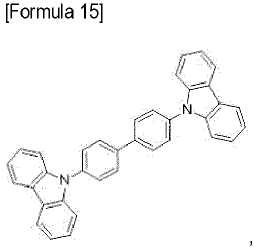 and

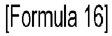

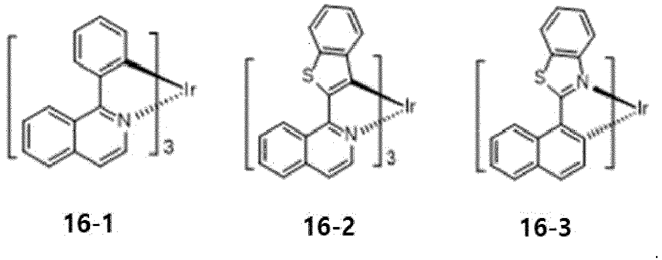

10. The organic light emitting display device (100) according to any preceding claim, wherein the fourth emitting material layer (440) includes fourth to sixth compounds (442, 444, 446),
wherein the fourth compound (442) is represented by Formula 6-1: 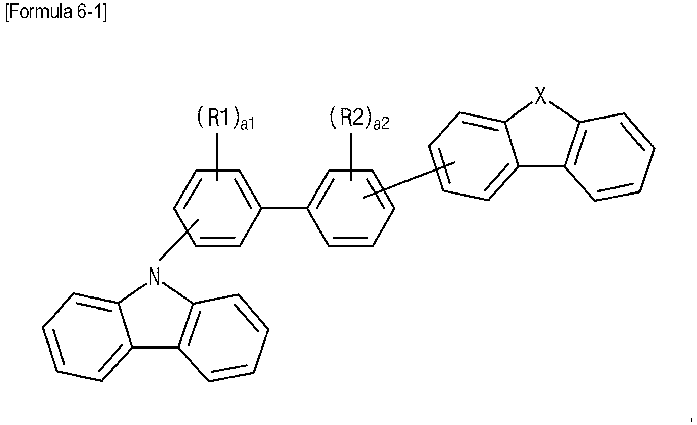
wherein in Formula 6-1, each of a1 and a2 is independently an integer of 0 to 4,
wherein each of R1 and R2 is independently selected from the group consisting of deuterium and a substituted or unsubstituted C1 to C10 alkyl group, or adjacent R1 and R2 is connected to each other to form a ring including O or S,
wherein X is selected from the group consisting of O, S and NR3, and R3 is selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group,
wherein the fifth compound (444) is represented by Formula 7-1: 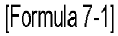 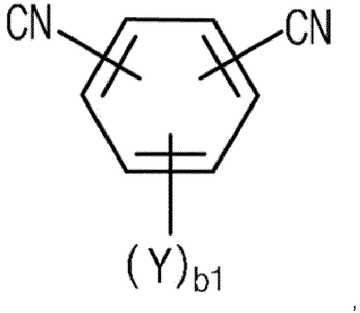
wherein in Formula 7-1, b1 is an integer of 1 to 4, and Y is represented by Formula 7-2: 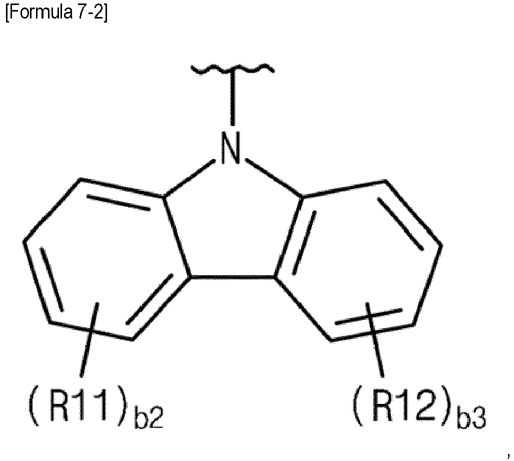
wherein in Formula 7-2, each of R11 and R12 is independently selected from the group consisting of deuterium, a substituted or unsubstituted C1 to C10 alkyl group, a substituted or unsubstituted C6 to C30 aryl group and a substituted or unsubstituted C5 to C30 heteroaryl group, and each of b2 and b3 is independently an integer of 0 to 4,
wherein the sixth compound (446) is represented by Formula 10-1: 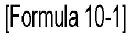 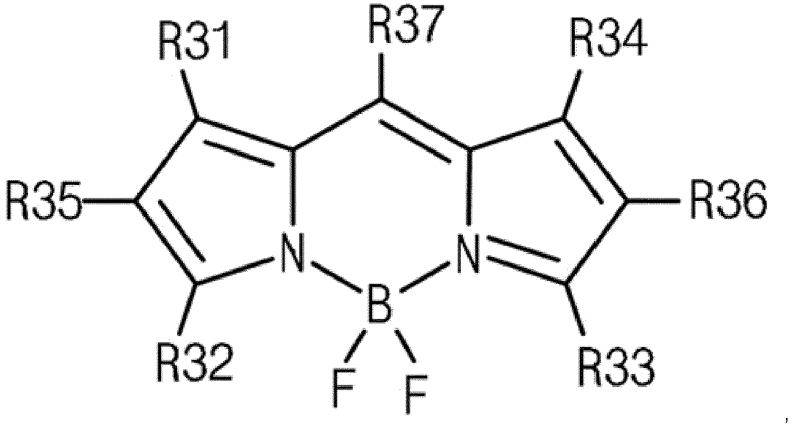
wherein in Formula 10-1, each of R31, R32, R33 and R34 is independently selected from the group consisting of hydrogen and a substituted or unsubstituted C1 to C10 alkyl group, and at least one of R31, R32, R33 and R34 is a substituted or unsubstituted C1 to C10 alkyl group, and
wherein each of R35, R36 and R37 is independently selected from the group consisting of hydrogen, deuterium, a substituted or unsubstituted C1 to C10 alkyl group, a substituted or unsubstituted C6 to C30 aryl group and a substituted or unsubstituted C5 to C30 heteroaryl group, and optionally wherein Formula 6-1 is represented by Formula 6-3: 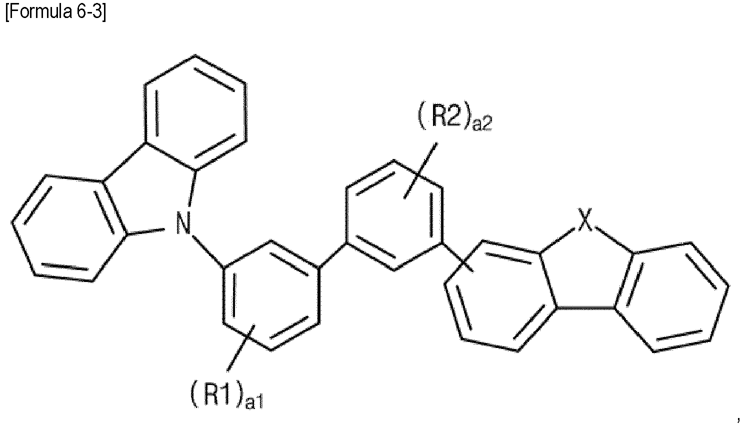 wherein the definitions of R1, R2, X, a1 and a2 are same as those in Formula 6-1,and further optionally wherein the fourth compound (442) is one of compounds in Formula 6-4:

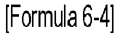

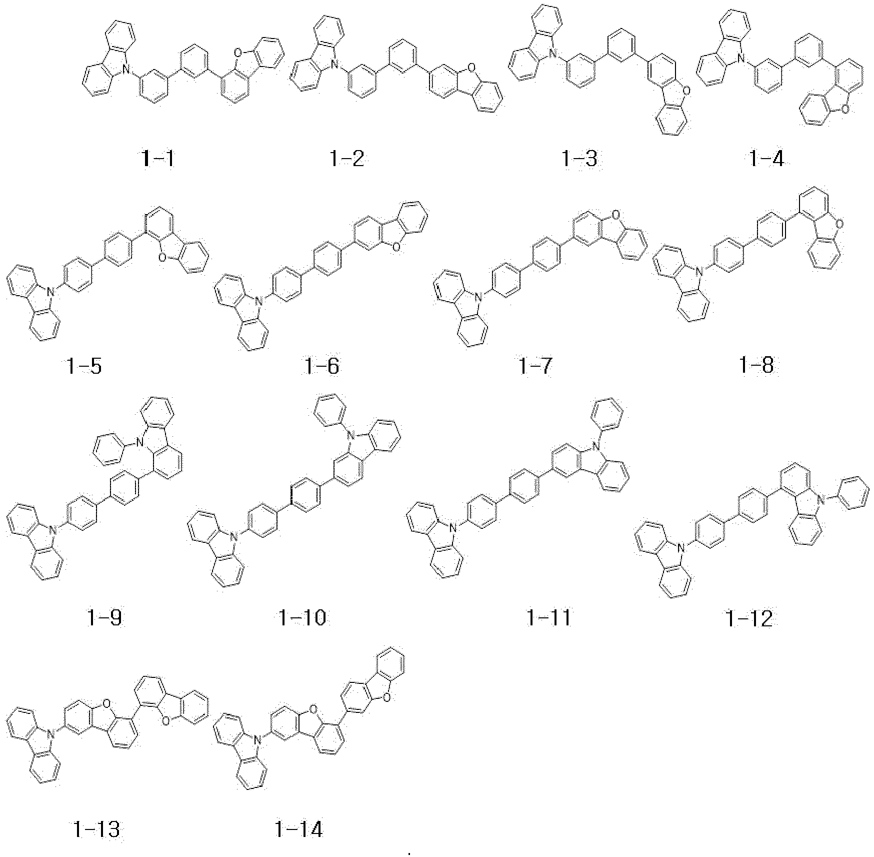

11. The organic light emitting display device (100) according to claim 10, wherein Formula 7-1 is represented by Formula 8-2: 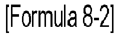 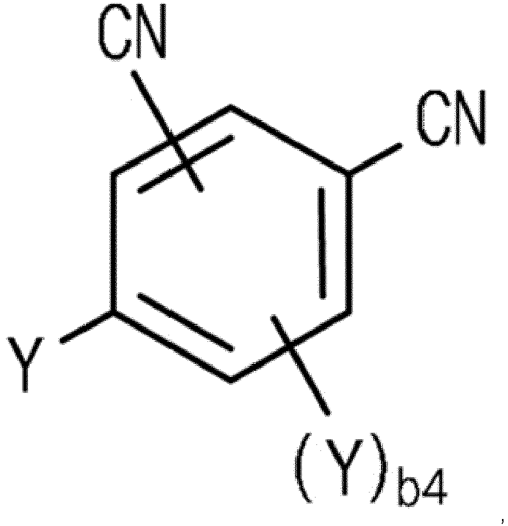 wherein Y is represented by Formula 7-2, and b4 is an integer of 0 to 3.

12. The organic light emitting display device (100) according to claim 10 or 11, wherein the fifth compound (444) is one of compounds in Formula 8-3: 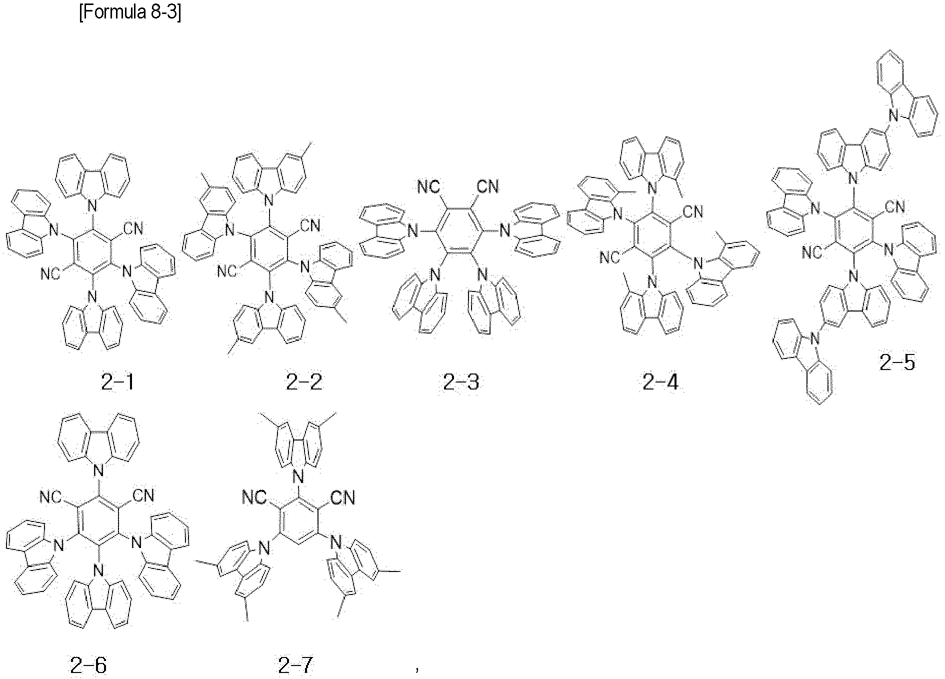 and/or
wherein the sixth compound (446) is one of compounds in Formula 10-2:

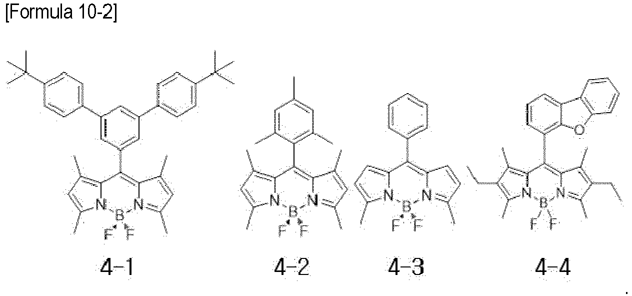

13. The organic light emitting display device (100) according to any of claims 10 to 12, wherein the third emitting material layer (420) includes a second host (422) and a second phosphorescent dopant (424), and
wherein the second host (422) is a compound in Formula 17, and the second phosphorescent dopant (424) is one of compounds in Formula 18: 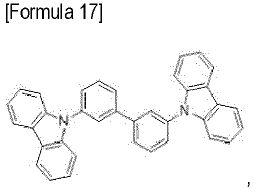 and

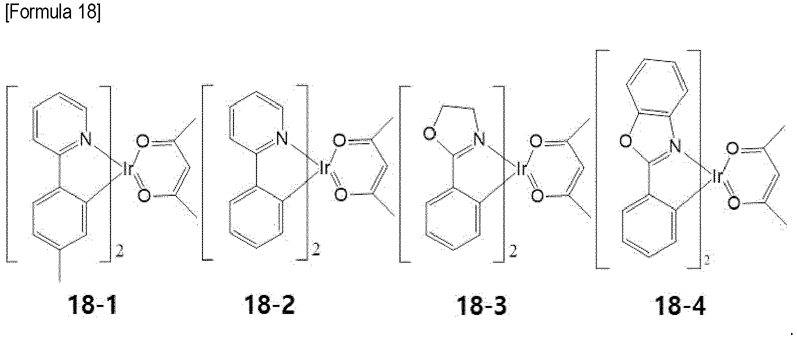

14. The organic light emitting display device (100) according to any preceding claim, wherein the second emitting part (530) further includes a second hole transporting layer (532) at one side of the second emitting material layer (540) and a second electron transporting layer (534) at the other side of the second emitting material layer (540), and/or, when dependent on claim 2,
wherein the third emitting part (610) further includes a third hole transporting layer (614) at one side of the third emitting material layer (620) and a third electron transporting layer (616) at the other side of the third emitting material layer (620).

15. The organic light emitting display device (100) according to claim 14 when dependent on claims 2, 4, 5 and 14, wherein the other side of the first emitting material layer (520) contacts the first hole blocking layer (517), and the other side of the second emitting material layer (540) contacts the second electron transporting layer (534), and
wherein the one side of the third emitting material layer (620) contacts the third hole transporting layer (614), and the one side of the fourth emitting material layer (640) contacts the first electron blocking layer (633), and/or wherein the first emitting part (510) further includes a second electron blocking layer between the first emitting material layer (520) and the first hole transporting layer (514), and the fourth emitting part (630) further includes a second hole blocking layer (635) between the fourth emitting material layer (440) and the fourth electron transporting layer (634), and optionally wherein the one side of the first emitting material layer (520) contacts the second electron blocking layer, and the one side of the second emitting material layer (540) contacts the second hole transporting layer (532), and
wherein the other side of the third emitting material layer (620) contacts the third electron transporting layer (616), and the other side of the fourth emitting material layer (640) contacts the second hole blocking layer (635).
